# EUROPEAN PATENT APPLICATION

(11) **EP 4 845 332 A1**
(43) Date of publication of application: **25.11.2026**
(21) Application number: 24939167.3
(22) Date of filing: 22.05.2024
(51) Int. Cl.: H10B 41/40, H10B 41/27, H10D 84/00

(54) **MEMORY DEVICE**

(71) Applicant: Yangtze Memory Technologies Co., Ltd., Wuhan, Hubei 430000 (CN)
(72) Inventor: ZHANG, Hao, Wuhan, Hubei 430000 (CN); ZHANG, Gang, Wuhan, Hubei 430000 (CN); DONG, Kuan, Wuhan, Hubei 430000 (CN); XIAO, Meng, Wuhan, Hubei 430000 (CN); LIU, Longdong, Wuhan, Hubei 430000 (CN); XIAO, Meng, Wuhan, Hubei 430000 (CN); HUO, Zongliang, Wuhan, Hubei 430000 (CN)
(74) Representative: Gramm, Lins & Partner Patent- und Rechtsanwälte PartGmbB
(86) International application number: PCT/CN2024/094810
(87) International publication number: WO 2025/241128

(57) **Abstract**

The present disclosure provides a memory device and relates to the semiconductor chip technology field, aiming at increasing the memory density of the memory device. The memory device includes a first stack structure, a second stack structure, a first connection structure and a bit line. The first stack structure includes a plurality of first gate layers and a plurality of first dielectric layers stacked alternatively in a first direction. The second stack structure includes a plurality of second gate layers and a plurality of second dielectric layers stacked alternatively in a first direction. The first connection structure is located on a side of the first stack structure and the second stack structure in the second direction, and is connected with at least one of the first gate layers and at least one of the second gate layers. The bit line is located between the first stack structure and the second stack structure and extends in a direction intersecting the first direction. With the above-described arrangement, one first gate layer and one second gate layer share one first connection structure, which facilitates improving the memory density of the memory device.

## Description

### TECHNICAL FIELD

The present disclosure relates to the field of semiconductor chip technology, and particularly to a memory device.

### BACKGROUND

As the feature sizes of memory cells approach the lower limit of process, planar process and manufacturing techniques have become challenging and costly, resulting in the memory density of 2D or planar NAND flash memory approaching an upper limit.

In order to overcome limitations on 2D or planar NAND flash memory, a memory with three-dimensional structure (3D NAND) have been developed in the industry, which improves the memory density by arranging memory cells on the substrate in three dimensions.

### SUMMARY

In one aspect, some examples of the present disclosure provide a memory device including a first stack structure, a second stack structure, a first connection structure and a bit line. The first stack structure includes a plurality of first gate layers and a plurality of first dielectric layers stacked alternatively in a first direction. The second stack structure includes a plurality of second gate layers and a plurality of second dielectric layers stacked alternatively in the first direction and is stacked with the first stack structure in the first direction. The first connection structure is located on a side of the first stack structure and the second stack structure in a second direction and connected with at least one of the first gate layers and at least one of the second gate layers, wherein the second direction intersects the first direction. The bit line is located between the first stack structure and the second stack structure and extends in a direction intersecting the first direction.

In some examples, the first connection structure includes a first connection sub-section and a second connection sub-section stacked in the first direction. The first connection sub-section comprises a first connection pillar extending in the first direction and at least one first connection layer parallel to the second direction, and one of the first connection layers connects the first connection pillar and one of the first gate layers. The second connection sub-section comprises a second connection pillar extending in the first direction and connected with the first connection pillar and at least one second connection layer parallel to the second direction, and one of the second connection layers connects the second connection pillar and one of the second gate layers.

In some examples, the first connection sub-section and the second connection sub-section are an integral structure.

In some examples, in the second direction, a size of an end of the first connection pillar close to the second connection pillar is greater than a size of an end of the second connection pillar close to the first connection pillar.

In some examples, in the second direction, the size of the end of the first connection pillar close to the second connection pillar is greater than a size of an end of the first connection pillar away from the second connection pillar; and/or in the second direction, a size of an end of the second connection pillar away from the first connection pillar is greater than a size of an end of the second connection pillar close to the first connection pillar.

In some examples, the first connection structure further includes a first isolation layer and a second isolation layer, the first isolation layer located on a side of the first connection layer close to the second connection layer and surrounding the first connection pillar, and the second isolation layer located on a side of the second connection layer away from the first connection layer and surrounding the second connection pillar.

In some examples, a size of an end of the first isolation layer away from the first connection layer and in the second direction is greater than a size of an end of the first isolation layer close to the first connection layer and in the second direction.

In some examples, the first connection structure further includes a third isolation layer and a fourth isolation layer, the third isolation layer located on a side of the first connection layer away from the first isolation layer and contacting and surrounding the first connection pillar, and the fourth isolation layer located on a side of the second connection layer away from the second isolation layer and contacting and surrounding the second connection pillar.

In some examples, the first connection layer comprises a first sub-layer and a second sub-layer stacked in the first direction, the first sub-layer is located between the first isolation layer and the second sub-layer, and the first isolation layer surrounds the first sub-layer.

In some examples, the memory device further comprises a third connection layer surrounding the connection pillar and connected with the first connection pillar, and in the first direction, an edge of the third connection layer on a side away from the first isolation layer is connected with the first connection layer; and the first connection layer surrounds the third connection layer and is connected with the first gate layer.

In some examples, the first isolation layer includes a first sub isolation layer surrounding the connection pillar, a second sub isolation layer located between the first sub isolation layer and the connection pillar and surrounding the connection pillar, and a third sub isolation layer located between the second sub isolation layer and the connection pillar and surrounding the connection pillar.

In some examples, an edge of the third connection layer on a side close to the second sub isolation layer extends towards a direction close to the second sub isolation layer.

In some examples, the memory device further includes a first select gate, a second select gate, a third select gate and a fourth select gate. The first select gate is located on a side of the first stack structure away from the second stack structure, the second select gate is located on a side of the first stack structure close to the second stack structure, and the third select gate is located on a side of the second stack structure close to the first stack structure. The bit line connects the second select gate and the third select gate. The fourth select gate is located on a side of the second stack structure away from the first stack structure.

In some examples, the first stack structure includes a first sub stack structure and a second sub stack structure stacked in the first direction; a first channel structure extending through the first sub stack structure and a second channel structure extending through the second sub stack structure; wherein the first channel structure is located between the first select gate and the second select gate.

In some examples, the memory device includes a first region and a second region adjoining the first region, the first stack structure and the second stack structure are both located in the first region, and the first connection structure is located in the second region; the second region is located on a side of the first region; or the first region comprises a first sub-region and a second sub-region and the second region is located between the first sub-region and the second sub-region.

In some examples, the memory device further includes a third stack structure and a fourth stack structure stacked in the first direction, with the third stack structure and the fourth stack structure both located in the second region; the first connection pillar extends through the third stack structure that comprises a plurality of third dielectric layers and a plurality of fourth dielectric layers stacked alternatively in the first direction, with at least one of the third dielectric layers connected with at least one of the first connection layers; the second connection pillar extends through the fourth stack structure that comprises a plurality of fifth dielectric layers and a plurality of sixth dielectric layers stacked alternatively in the first direction, with at least one of the fifth dielectric layers connected with at least one of the second connection layers.

In some examples, the memory device further includes a second connection structure located on a side of the first stack structure and the second stack structure in the second direction; one of the first select gate and the second select gate is connected with the second connection structure.

In another aspect, some examples of the present disclosure further provide a memory device including a first stack structure, a second stack structure and a first connection structure. The first stack structure includes a plurality of first gate layers and a plurality of first dielectric layers stacked alternatively in a first direction. The second stack structure includes a plurality of second gate layers and a plurality of second dielectric layers stacked alternatively in the first direction and is stacked with the first stack structure in the first direction; The first connection structure includes a connection pillar, at least one first connection layer and at least one second connection layer, wherein the connection pillar is located on a side of the first stack structure and the second stack structure in a second direction, the first connection layer is parallel to the second direction, one of the first connection layer connects the connection pillar and one of the first gate layers; the second connection layer is parallel to the second direction, one of the second connection layers connects the connection pillar and one of the second gate layers; and the second direction intersects the first direction.

In some examples, the memory device further includes a first select gate, a second select gate, a third select gate, a fourth select gate and a second connection structure. The first select gate is located on a side of the first stack structure away from the second stack structure. The second select gate is located on a side of the first stack structure close to the second stack structure. The third select gate is located on a side of the second stack structure close to the first stack structure. The fourth select gate is located on a side of the second stack structure away from the first stack structure. The second connection structure is located on a side of the first stack structure and the second stack structure in the second direction. One of the first select gate, the second select gate, the third select gate and the fourth select gate is connected with the second connection structure.

In some examples, the memory device further includes a first bit line and a second bit line, wherein the first bit line is located on a side of the first select gate away from the first stack structure, the second bit line is located on a side of the fourth select gate away from the first stack structure; and the first bit line and the second bit line have an extending direction intersecting the first direction.

In some examples, the memory device includes a first region and a second region, the first region and the second region adjoining each other in the second direction, the first stack structure and the second stack structure are both located in the first region, and the first connection structure is located in the second region; the second region is located on a side of the first region; or the first region comprises a first sub-region and a second sub-region and the second region is located between the first sub-region and the second sub-region.

In yet another aspect, some examples of the present disclosure further provide a memory device including a first stack structure and a second stack structure stacked in a first direction, a first select gate, a second select gate and a bit line. The first stack structure includes a plurality of first gate layers and a plurality of first dielectric layers stacked alternatively in the first direction, the second stack structure includes a plurality of second gate layers and a plurality of second dielectric layers stacked alternatively in the first direction. The first select gate is located on a side of the first stack structure close to the second stack structure and the second select gate is located on a side of the second stack structure close to the first stack structure. The bit line is located between the first select gate and the second select gate and extends in a direction intersecting the first direction.

In some examples, the memory device further includes a first connection structure. The first connection structure is located on a side of the first stack structure and the second stack structure in a second direction and connected with at least one of the first gate layers and at least one of the second gate layers, and the second direction intersects the first direction.

In some examples, the memory device further includes: a third select gate located on a side of the first stack structure away from the second stack structure, a fourth select gate located on a side of the second stack structure away from the first stack structure, and a second connection structure. The second connection structure is located on a side of the first stack structure and the second stack structure in the second direction. One of the first select gate, the second select gate, the third select gate and the fourth select gate is connected with the second connection structure.

### BRIEF DESCRIPTION OF DRAWINGS

In order to illustrate technical solutions in the present disclosure more clearly, drawings needed in the description of some examples of the present disclosure will be briefly introduced. Apparently, drawings in the following description are drawings of only some examples of present disclosure and, in view of them, other drawings can be obtained by those skilled in the art according to these drawings. Furthermore, accompanying drawings described below may be regarded as illustrative diagrams, rather than limiting the practical sizes of products, practical flows of methods and practical timings of signals involved in examples of the present disclosure.
Fig. 1 is a block diagram of an electronic apparatus according to some examples;
Fig. 2 is a block diagram of a memory system according to some examples;
Fig. 3 is a block of a memory system according to some other examples;
Fig. 4 is a schematic diagram of three-dimensional structure of a memory device according to some examples;
Fig. 5 is a cross section view of a memory device according to some examples;
Fig. 6 is a cross section view along cross-sectional line AA' of a memory cell string in the memory device shown in Fig. 4;
Fig. 7 is an equivalent circuit diagram of a memory cell string shown in Fig. 6;
Fig. 8 is a circuit diagram of a memory device according to some examples;
Fig. 9 is a structure diagram of a memory device according to some examples;
Fig. 10 is a structure diagram of a memory device according to some other examples;
Fig. 11 is a structure diagram of a memory device in the Y-Z cross section according to some examples;
Fig. 12 is a structure diagram of a memory device in the Y-Z cross section according to some other examples;
Figs. 13-15 are structure diagrams of a memory device according to different examples;
Fig. 16 is a circuit diagram of a memory device according to some other examples;
Fig. 17 is a structure diagram of a memory device according to some other examples;
Fig. 18 is a flowchart of a manufacturing method of a memory device according to some examples;
Figs. 19-43 are structure diagrams of a memory device during the manufacturing process according to some examples;
Fig. 44 is a flowchart of a manufacturing method of a memory device according to some other examples;
Fig. 45 is a flowchart of a manufacturing method of a memory device according to some other examples; and
Fig. 46 is a structure diagram of a memory device during the manufacturing process according to some other examples.

### DETAILED DESCRIPTION

The technical solution in some examples of the present disclosure will be described below clearly and completely with reference to accompanying drawings. However, it is obvious that the described examples are only some examples rather than all examples of the present disclosure. All other examples obtained by one of ordinary skill in the art based on examples provided in the present disclosure fall within the scope of the present disclosure.

In the description of the present disclosure, it is to be understood that terms "center", "on", "under", "front", "back", "left", "right", "vertical", "horizontal", "top", "bottom", "inside", "outside" etc. refer to the orientation or position relationship which is based on what is shown in figures, which are only for the purpose of facilitating describing the present disclosure and simplifying description rather than indicating or implying that the mentioned devices or elements must have certain orientation, must be constructed and operated in certain orientation, and therefore are not constructed as limiting the present disclosure.

Unless otherwise stated in context, the term "include" will be interpreted in an open and containing sense, namely "contain but not limited to" throughout the description and claims. In the description of the specification, the terms "one example", "some examples", "example implementations", "as an example" or "some examples" are intended to mean that specific feature, structure, material or characteristic related to the examples or implementations are included in at least one example or implementation of the present disclosure. The illustrative representation of the above terms does not necessarily refer to the same example or implementation. Furthermore, the particular feature, structure, material or characteristic may be included in any suitable way in any one or more examples or implementations.

Hereinbelow, terms such as "first", "second" etc. are only used for description rather than being interpreted as indicating or implying relative importance or implicitly indicating the number of the indicated technical features. Therefore, a feature defined by "first" or "second" may include explicitly or implicitly one or more instances of the feature. In the description of the examples of the present disclosure, "a plurality of" means two or more unless otherwise specified.

While describing some examples, expressions such as "couple" and "connect" as well as their extensions might be used. For example, the term "connect" may be used while describing some examples to indicate that two or more components have direct physical contact or electrical contact. As another example, the term "couple" may be used while describing some examples to indicate that two or more components have direct physical contact or electrical contact. However, the term "couple" may also indicate there is no direct contact between two or more components, but they still cooperate or interact with each other. Examples disclosed herein are not necessarily limited to the contents provided herein.

"At least one of A, B and C" and "at least one of A, B or C" have the same meaning and both include the following combinations of A, B and C: only A; only B; only C; a combination of A and B; a combination of A and C; a combination of B and C; and a combination of A, B and C.

"A and/or B" includes the following three combinations: only A, only B and a combination of A and B.

The use of "adapted to" or "configured to" in the present description implies open and inclusive wording but not excluding apparatuses adapted to or configured to execute additional tasks or steps.

In addition, the use of "based on" implies openness and inclusiveness, since a process, a step, a computation or other actions "based on" one or more said conditions or values may be based on additional conditions or values other than said value in practice.

As used herein, "about", "generally" or "approximately" includes the stated value and the average value in the acceptable deviation range of a certain value, wherein said acceptable deviation range is determined by those of ordinary skill in the art considering the measurements under discussion and errors, namely limitations of the measurement system, related to measurements of a certain quantity.

In the present disclosure, the meanings of "on", "over" and "above" should be interpreted in the broadest manner such that "on" not only means "directly on" something but also includes the meaning of "on" something with an intermediate feature or a layer therebetween, and that "over" or "above" not only means the meaning of "over" or "above" something but can also include the meaning of "above" or "over" something with no intermediate feature or layer therebetween (i.e., directly on something).

Example implementations are described herein with reference to cross section views and/or plan views as ideal illustrative drawings. In the drawings, thicknesses of layers and regions may be exaggerated for clear illustration. Therefore, it is possible to envision shape variations with respect to drawings due to manufacturing techniques and/or tolerances for example. Accordingly, example implementations should not be interpreted as limiting to the shapes of regions shown herein, but including shape deviations caused by for example manufacturing. For example, an etched region shown as rectangular generally has curved features. Therefore, regions shown in drawings are illustrate in nature, and their shapes are not intended to show practical shapes of regions of an apparatus and not intended to limit the scope of example implementations.

As used herein, the term "substrate" refers to a material on which subsequent material layers may be added. The substrate may be patterned itself. Materials added on the substrate may be patterned or may be kept unpatterned. Furthermore, the substrate may include a plurality of semiconductor materials such as silicon, germanium, gallium arsenide and indium phosphide. Alternatively, the substrate may be made of non-conductive materials such as glass, plastics or sapphire wafer.

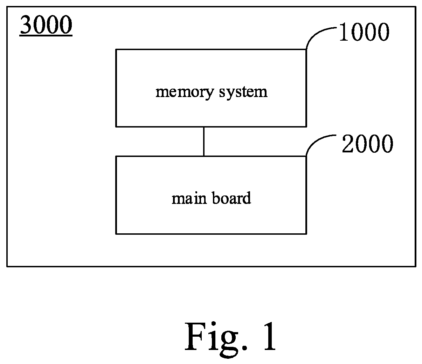

Some examples of the present disclosure provide an electronic apparatus. Fig. 1 is a block diagram of an electronic apparatus according to some examples. As shown in Fig. 1, the electronic apparatus 3000 includes a main board 2000 and a memory system 1000, wherein the main board 2000 is electrically connected with the memory system 1000. In addition, the electronic apparatus 3000 may further include at least one of a central processing unit (CPU) and a cache.

Illustratively, the electronic apparatus 3000 may be any one of a mobile phone, a desktop computer, a tablet, a notebook, a server, an on-vehicle apparatus, a wearable apparatus such as a smart watch, a smart bracelet and a pair of smart glasses, a mobile power source, a game console, a digital multimedia player etc.

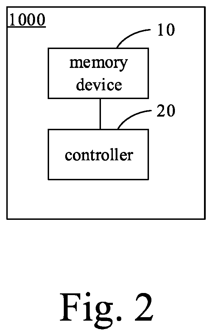

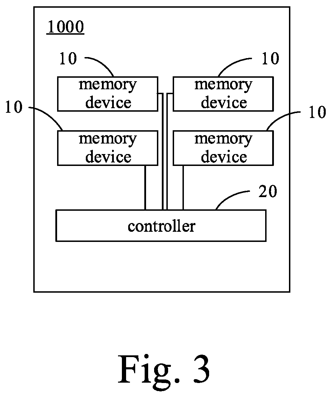

Fig. 2 is a block diagram of a memory system according to some examples. Fig. 3 is a block of a memory system according to some other examples.

Referring to Figs. 2 and 3, some examples of the present disclosure further provide a memory system 1000. The memory system 1000 includes a controller 20 and a memory device 10. The controller 20 is coupled with the memory device 10 to control the memory device 10 to store data.

The memory system 1000 may be integrated into various types of storage apparatus such as being included in the same package (such as Universal Flash Storage (UFS) package) or Embedded Multi Media Card (eMMC) package. That is, the memory system 1000 can be applied to and packaged in different types of electronic products such as a mobile phone (e.g., a handset), a desktop computer, a tablet, a notebook, a server, an on-vehicle apparatus, a gaming console, a printer, a positioning device, a wearable apparatus, a smart sensor, a mobile power source, a virtual reality (VR) apparatus, an argument reality (AR) apparatus, or any other suitable electronic apparatus having a storage therein.

In some examples, referring to Fig. 2, the memory system 1000 includes a controller 20 and a memory device 10 and may be integrated in a memory card. Illustratively, the memory device 10 may be a memory with three-dimensional structure (3D NAND).

The memory card includes any one of a PC card (PCMCIA, Personal Computer Memory Card International Association), a Compact Flash (CF) card, a Smart Media (SM) card, a memory stick, a Multimedia Card (MMC), a Secure Digital Memory Card (SD) or a UFS.

In some other examples, referring to Fig. 3, the memory system 1000 includes a controller 20 and a plurality of memory devices 10 and is integrated in a solid state drive (SSD) device.

In the memory system 1000, in some examples, the controller 20 is configured to operate in low duty cycle environment, such as SD device cards, CF cards, Universal Serial Bus (USB) flash drives, or other medium used in electronic apparatus such as personal calculators, digital cameras and mobile phones.

In some other examples, the controller 20 is configured to operate in high duty cycle environment SSD devices or eMMCs that are used as data storage of the mobile apparatus such as smart phones, tablets and notebooks, and enterprise memory arrays.

In some examples, the controller 20 may be configured to manage the data stored in memory device 10 and communicate with external equipment (such as a host). In some examples, the controller 20 may be configured to control operations of the memory device 10, such as read, erase, and program operations. In some examples, the controller 20 may also be configured to manage various functions with respect to the data stored or to be stored in the memory device 10, including at least one of bad-block management, garbage collection, logical-to-physical address conversion, wear leveling, etc. In some examples, the controller 20 is further configured to process error correction codes with respect to the data read from or written to the memory device 10.

Of course, any other suitable functions may be performed by the controller 20 as well, for example, formatting the memory device 10. For example, the controller 20 may communicate with the external equipment such as a host through at least one of various interface protocols.

It is to be noted that the interface protocols include at least one of USB protocol, MMC protocol, peripheral component interconnection (PCI) protocol, PCI-express (PCI-E) protocol, advanced technology attachment (ATA) protocol, serial-ATA protocol, parallel-ATA protocol, small computer small interface (SCSI) protocol, enhanced small disk interface (ESDI device) protocol, integrated drive electronics (IDE) protocol and Firewire protocol.

The controller 20 in the above-described examples may be for example a central processing unit (CPU), a general-purpose processor, a digital signal processor (DSP), an application-specific integrated circuit (ASIC), a field programmable gate array (FPGA) or other programmable logic device, transistor logic device, hardware component or any combination thereof.

Some examples of the present disclosure provide a memory device 10. The memory device 10 may be applied in the above-described memory system 1000. Of course, the memory device 10 may also be applied in other memory systems, which is not limited herein.

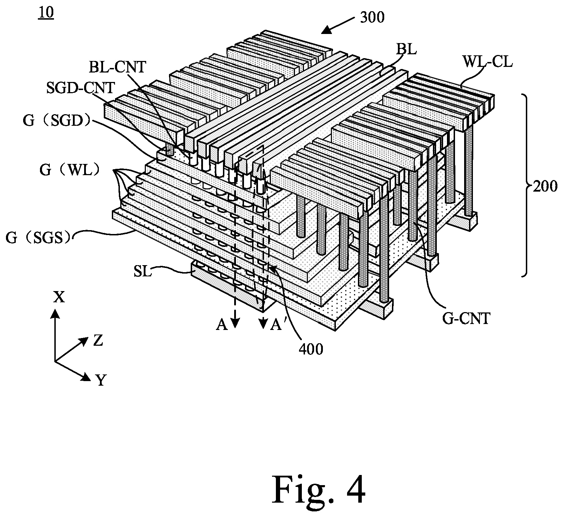

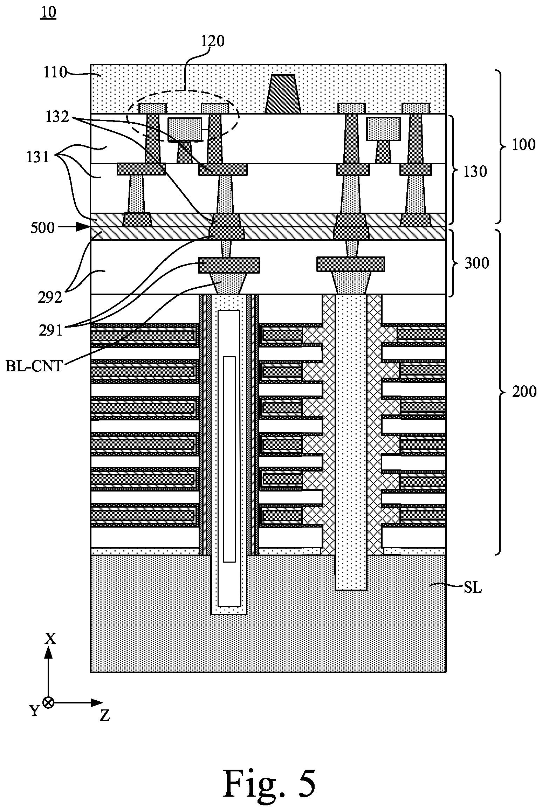

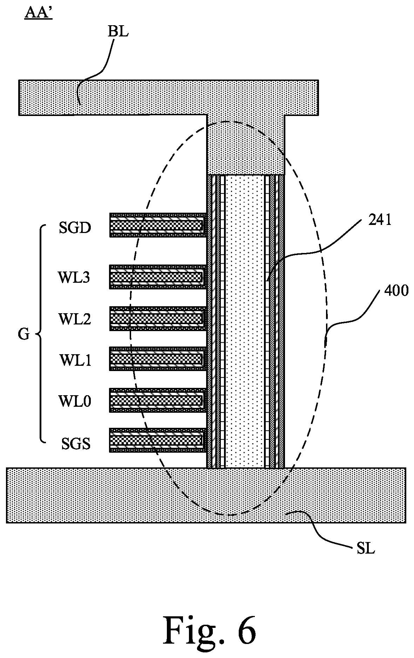

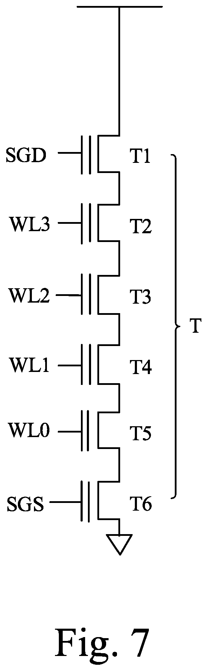

Fig. 4 is a schematic diagram of three-dimensional structure of a memory device according to some examples, Fig. 5 is a cross section view of a memory device according to some examples, Fig. 6 is a cross section view along cross-sectional line AA' of a memory cell string in the memory device shown in Fig. 4, and Fig. 7 is an equivalent circuit diagram of the memory cell string shown in Fig. 6.

It is to be noted that in Figs. 4 and 5, the first direction X and the second direction Y may be two intersecting directions, and the third direction Z may intersect the X-Y plane. The present disclosure takes the following case as an example to describe the semiconductor structure 200: the second direction Y and the third direction Z are two orthogonal directions in the plane where the semiconductor structure 200 is located (such as the plane where the semiconductor layer is located); the second direction Y is for example an extending direction of the word line WL; the third direction Z is for example an extending direction of the bit line BL; the first direction X is perpendicular to the two orthogonal directions in the plane where the semiconductor structure 200 is located, namely perpendicular to the X-Y plane. The memory device 10 extends in the Y-Z plane.

As used in the present disclosure, whether a component (e.g., a layer, a structure or a device) is "on", "over" or "under" another component (e.g., a layer, a structure or a device) in the semiconductor device (such as a memory device) is determined with respect to the semiconductor layer of the semiconductor device in the first direction X when the semiconductor layer is located in the bottom plane of the semiconductor device in the first direction X. In the entire disclosure, same concepts are applied to describe spatial relationship.

Referring to Figs. 4 and 5, some examples of the present disclosure provide a memory device 10. The memory device 10 may include a semiconductor structure 200 and a peripheral device 100 coupled with the semiconductor structure 200. The peripheral device 100 may be disposed on a side of the semiconductor structure 200.

The semiconductor structure 200 may include a semiconductor layer. The constituting material for semiconductor layer may include for example single crystalline silicon, single crystalline germanium, III-V compound semiconductor materials, II-VI compound semiconductor materials and other semiconductor materials.

The semiconductor structure 200 may further include memory cell transistor strings ("memory cell strings" herein, e.g., NAND memory cell strings) 400 arranged in an array. The semiconductor layer may include a source layer SL that may be coupled with source ends of a plurality of memory cell strings 400. Illustratively, the source layer SL may be partially or completely doped. For example, the source layer SL may include a doped region doped with a p-type dopant. The source layer may also include a non-doped region.

In particular, referring to Figs. 6 and 7, the memory cell string 400 may include a plurality of transistors T. One transistor T (such as T1-T6 in Fig. 7) may be configured as one memory cell. These transistors T are connected together to form the memory cell string. A transistor T (such as each transistor T) may be formed by the channel structure 240 and a gate line G surrounding the channel structure 240. The gate line G is configured to control the conduction state of the transistor.

It is to be noted that the number of transistors in Figs. 4-7 is only illustrative. The memory cell string in the memory device provided in examples of the present disclosure may also include other number of transistors, such as 4, 16, 32 and 64.

Further, in the third direction Z, the bottom one of the plurality of gate lines G (such as the one of the plurality of gate lines G closest to the source layer SL) is configured as the source end select gate SGS, and the source end select gate SGS is configured to control the conduction state of the transistor T6 and in turn control the conduction state of the source end path in the memory cell string 400. The top one of the plurality of gate lines G (such as the one of the plurality of gate lines G farthest from the source layer SL) is configured as the drain end select gate SGD, and the drain end select gate SGD is configured to control the conduction state of the transistor T1 and in turn control the conduction state of the drain end path in the memory cell string 400. The gate line located in the middle among the plurality of gate lines G may be configured a plurality of word lines WL, including for example word line WL0, word line WL1, word line WL2 and word line WL3. It is possible to implement data writing, reading and erasing of various memory cells such as transistors T in the memory cell string 400 by writing different voltages on the word lines WL.

Referring again to Figs. 4 and 5, in some examples, the semiconductor structure 200 may further include an array interconnection layer 300. The array interconnection layer 300 may be coupled with the memory cell string 400. The array interconnection layer 300 may include the drain end of the memory cell string 400, namely bit line BL. The drain end may be coupled with the semiconductor channels of the various transistors T in at least one memory cell strings 400.

The array interconnection layer 300 may include one or more first interlayer insulating layers 292, and may further include a plurality of contacts insulated from each other through these first interlayer insulating layers 292. The contacts include for example bit line contacts BL-CNT coupled with bit lines BL; drain end select gate contacts SGD-CNT coupled with the drain end select gates SGD; and gate line contacts G-CNT coupled with the gate lines G. The array interconnection layer 300 may further include one or more first interconnection conductor layers 291. The first interconnection conductor layers 291 may include a plurality of connection lines, such as the bit lines BL and word line connection lines coupled with the word lines WL-CL. The material for the first interconnection conductor layer 291 and the contact may be conductive material such as a combination of one or more of tungsten, cobalt, copper, aluminum and metal silicide, and may also be other conductive materials. The material for the first interlayer insulating layer 292 is an insulating material such as a combination of one or more of silicon oxide, silicon nitride and high dielectric constant insulating material, and may also be other insulating materials.

The peripheral device 100 may include a peripheral circuit. The peripheral circuit is configured to control and sense the array devices. The peripheral circuit may be any suitable digital, analog or hybrid signal control and sense circuit for supporting the operation (or work) of the array device, including, but not limited to a page buffer, a decoder (such as a row decoder and a column decoder), a sense amplifier, a driver (such as a word line driver), a charge pump, a current or voltage reference or any active or inactive components of a circuit such as a transistor, a diode, a resistor or a capacitor. The peripheral circuit may further include any other circuits compatible with advanced logic processes, including a logic circuit such as a processor and a programmable logic device (PLD) or a memory circuit such as a static random-access memory (SRAM).

In particular, in some examples, the peripheral device 100 may include a substrate 110, a transistor 120 disposed on the substrate 110 and a peripheral interconnection layer 130 disposed on the substrate 110. The peripheral circuit may include a transistor 120.

The material for the substrate 110 may be single crystalline silicon or other suitable materials such as silicon germanium, germanium or silicon-on-insulator thin film.

The peripheral interconnection layer 130 is coupled with the transistor 120 for electric signal transmission between the transistor 120 and the peripheral interconnection layer 130. The peripheral interconnection layer 130 may include one or more second interlayer insulating layers 131 and may further include one or more second interconnection conductor layers 132. Different second interconnection conductor layers 132 may be coupled through contacts. The material for the second interconnection conductor layer 132 and contact may be conductive material such as a combination of one or more of tungsten, cobalt, copper, aluminum and metal silicide, and may also be other suitable materials. The material for the second interlayer insulating layer 131 is an insulating material such as a combination of one or more of silicon oxide, silicon nitride and high dielectric constant insulating material, and may also be other suitable materials.

The peripheral interconnection layer 130 may be coupled with the array interconnection layer 300 such that the semiconductor structure 200 may be coupled with the peripheral device 100. In some examples, since the peripheral interconnection layer 130 is coupled with the array interconnection layer 300, the peripheral circuit in the peripheral device 100 may be coupled with the memory cell strings in the semiconductor structure 200 for electrical signal transmission between the peripheral circuit and the memory cell strings. In some possible implementations, there may be provided a bonding interface 500 between the peripheral interconnection layer 130 and the array interconnection layer 300 by which the peripheral interconnection layer 130 and the array interconnection layer 300 may be bonded and coupled with each other.

At present, users are seeking memory devices with large capacity and small volume. Referring again to Fig. 4, in order to improve the capacity of a memory device, the number of stacked layers of gate lines G is becoming more and more. However, one gate line G is connected with one gate line contact G-CNT. As the number of layers of gate lines G increases, the number of gate line contacts G-CNT coupled with gate lines G increases too. Then, an area occupied by the gate line contacts G-CNT increases, resulting in increased size of the memory device in the second direction, which impedes increasing memory density of the memory device and impedes the development of memory device to smaller volume.

Also, the gate line G is coupled with the SD device (string driver) through the gate line contact G-CNT. However, one gate line contact G-CNT is connected with one SD device. As the number of gate line contacts G-CNT increases, the number of SD devices increases too, resulting in an increased area occupied by the SD devices, which impedes development of memory devices to smaller volume.

In addition, as the number of stacked layers of gate lines G increases, the number of SD devices increases too. In order to control the size of the memory device, how to scale down the size of SD device is a problem to be addressed in the field.

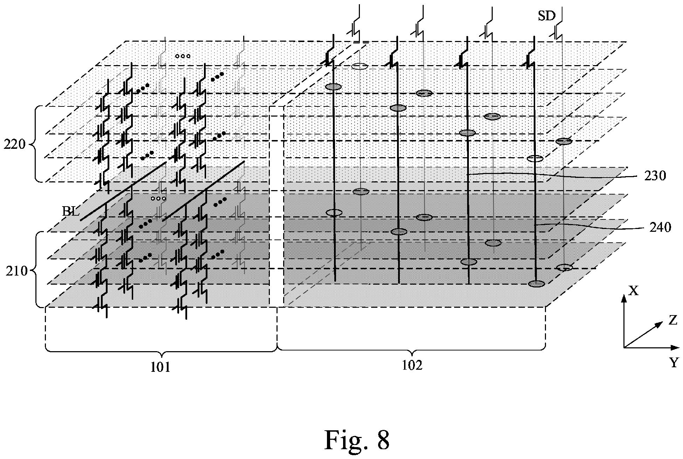

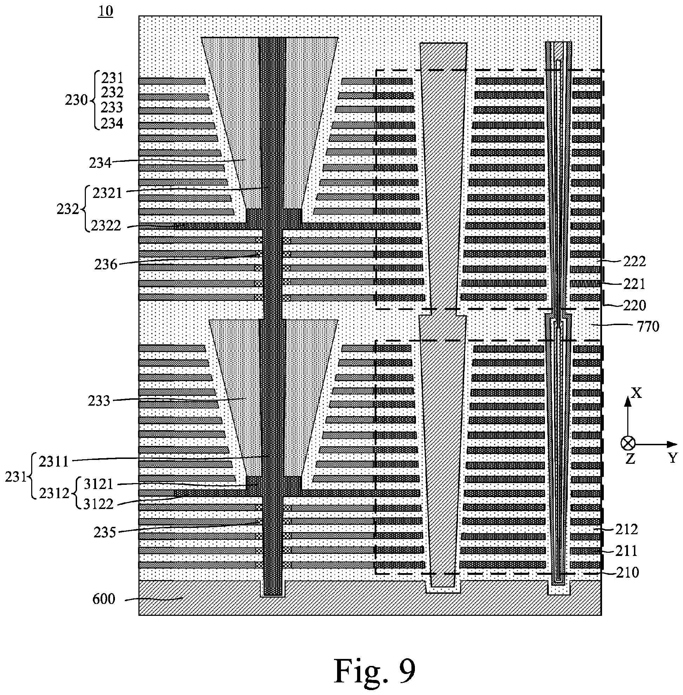

Fig. 8 is a circuit diagram of a memory device according to some examples. Fig. 9 is a structure diagram of a memory device according to some examples. As shown in Figs. 8 and 9, some examples of the present disclosure provide a memory device 10 including a first stack structure 210, a second stack structure 220, a first connection structure 230 and a bit line BL.

The first stack structure 210 may be disposed on the semiconductor layer 600. Illustratively, the first stack structure 210 may be in direct contact with the semiconductor layer 600. Illustratively, the constituting material for semiconductor layer 600 may include for example single crystalline silicon, single-crystalline germanium, III-V compound semiconductor materials, II-V compound and other suitable semiconductor materials.

The first stack structure 210 includes a plurality of first gate layers 211 and a plurality of first dielectric layers 212 stacked alternatively in the first direction X. For example, the first gate layers 211 and the first dielectric layers 212 stacked alternatively in the first direction X are stacked to form a plurality of first gate layers 211 and a plurality of first dielectric layers 212 spaced apart from each other. It is also understood as that one first gate layer 211 and one first dielectric layer 212 together constitute one first gate structure pair, and the first stack structure 210 includes a plurality of first gate structure pairs stacked in the first direction X.

Illustratively, the number of the first gate layers 211 and the first dielectric layers 212 may be 4, 16, 32, 64, 128, 256, etc. The thickness (namely the size in the first direction X) of the first gate layer 211 may be approximately equal to or different from the thickness of the first dielectric layer 212. For example, the thickness of the first dielectric layer 212 is greater than the thickness of the first gate layer 211.

Illustratively, the first gate layers 211 may include conductive materials including, but not limited to a combination of one or more of tungsten (W), cobalt (Co), copper (Cu), aluminum (Al), polysilicon, doped silicon, silicide, or may also be other suitable conductive materials. In some examples, the first gate layer 211 includes a metal layer such as a tungsten layer. In some examples, the first gate layer 211 includes a doped polysilicon layer. It is possible to dope polysilicon to a desired doping concentration with suitable dopant such that the polysilicon can become conductive material which serves as the first gate layers 211.

Illustratively, the first dielectric layers 212 may include an insulating material that may include a combination of one or more of silicon oxide, silicon nitride, silicon oxynitride and high dielectric constant insulating material, or other suitable insulating materials. The dielectric constant of the silicon oxynitride is higher than that of the silicon oxide. For example, in an environment under about 20°C, the dielectric constant of silicon oxynitride is between 4~7, for example, 3.8, 4, 4.8, 5.3, 5.9, 6, 6.36, 6.88, 7, 7.2 etc. In some examples, the first dielectric layer 212 includes a silicon oxide layer. In some examples, the first dielectric layer 212 includes a silicon oxynitride layer.

Illustratively, the thickness (namely the size in the first direction X) of the first gate layer 211 may be between 10nm~50nm, for example, 10nm, 15nm, 18.3nm, 20nm, 25nm, 27.7nm, 30nm, 35nm, 40nm, 45nm, 50nm etc. Similarly, the thickness (namely the size in the third direction Z) of the first dielectric layer 212 may be between 10nm~50nm, for example, 10nm, 15nm, 18.3nm, 20nm, 25nm, 27.7nm, 30nm, 35nm, 40nm, 45nm, 50nm etc. The first gate layer 211 may be the gate line G surrounding the memory cell string (referring to Fig. 6) and may extend laterally (i.e., in the second direction Y) as a word line WL (referring to Fig. 4).

The second stack structure 220 includes a plurality of second gate layers 221 and a plurality of second dielectric layers 222 stacked alternatively in the first direction X. For example, the second gate layers 221 and the second dielectric layers 222 stacked alternatively in the first direction X are stacked to form a plurality of second gate layers 221 and a plurality of second dielectric layers 222 spaced apart from each other.

It is appreciated that the example of the materials, thicknesses and number of the first gate layers 211 and the first dielectric layers 212 above may be referred to for the materials, thicknesses and number of the second gate layers 221 and the second dielectric layers 222. The materials, thicknesses and number of the second gate layers 221 and the first gate layers 211 may be the same or different, and the materials, thicknesses and number of the second dielectric layers 222 and the first dielectric layers 212 may be the same or different.

As shown in Fig. 9, the second stack structure 220 and the first stack structure 210 are stacked in the first direction X. An isolating dielectric layer 770 is disposed between the first stack structure 210 and the second stack structure 220, and the thickness of the isolating dielectric layer 770 is much greater than the thickness of the first dielectric layer 212 (or the second dielectric layer 222) in the first direction X. Illustratively, in the first direction X, the thickness of the isolating dielectric layer 770 may be 2-10 times the thickness of the first dielectric layer 212. For example, in the first direction X, the thickness of the isolating dielectric layer 770 may be 2, 6 or 10 times the thickness of the first dielectric layer 212. While the thickness of the isolating dielectric layer 770 approaches 2 times the thickness of the first dielectric layer 212, the spacing between the first stack structure 210 and the second stack structure 220 is small, which facilitates improving the memory density of the memory device 10. While the thickness of the isolating dielectric layer 770 approaches 10 times the thickness of the first dielectric layer 212, it is in favor of improving the isolation effect between the first stack structure 210 and the second stack structure 220.

The constituting material for the isolating dielectric layer 770 may be the same as the constituting material for the first dielectric layer 212 (or the second dielectric layer 222). Illustratively, the top layer of the first stack structure 210 (the layer of the first stack structure 210 that is closest to the second stack structure 220) may be the first dielectric layer 212. When forming the topmost first dielectric layer 212 in the first stack structure 210, the thickness of the topmost first dielectric layer 212 may be increased to isolate the first stack structure 210 and the second stack structure 220. Here, the thickened topmost first dielectric layer 212 may serve as the isolating dielectric layer 770 between the first stack structure 210 and the second stack structure 220. Illustratively, the bottom layer of the second stack structure 220 (the layer of the second stack structure 220 that is closest to the first stack structure 210) may be the second dielectric layer 222. When forming the bottommost second dielectric layer 222 in the second stack structure 220, the thickness of the bottommost second dielectric layer 222 may be increased to isolate the first stack structure 210 and the second stack structure 220. Here, the thickened bottommost second dielectric layer 222 may serve as the isolating dielectric layer 770 between the first stack structure 210 and the second stack structure 220.

In the present example, as shown in Figs. 8 and 9, the first connection structure 230 is located on a side of the first stack structure 210 and the second stack structure 220 in the second direction Y. Illustratively, the memory device 10 may include a first region 101 and a second region 102, the first region 101 and the second region 102 adjoining each other in the second direction Y. Both the first stack structure 210 and the second stack structure 220 may be located in the first region 101 and the first connection structure 230 may be located in the second region 102.

The first connection structure 230 is configured to connect the first gate layer 211 and the SD device and connect the second gate layer 221 and the SD device. Illustratively, the constituting material for the first connection structure 230 may include conductive materials including, but not limited to a combination of one or more of tungsten (W), cobalt (Co), copper (Cu), aluminum (Al), polysilicon, doped silicon, silicide, or may also be other suitable conductive materials.

Also, as shown in Figs. 8 and 9, the first connection structure 230 is connected with at least one first gate layer 211 and the first connection structure 230 is connected with at least one second gate layer 221. For example, in Fig. 9, the first connection structure 230 is connected with one of the first gate layers 211 in the first stack structure 210 and the first connection structure 230 is connected with one of the second gate layers 221 in the second stack structure 220. The end of the first connection structure 230 away from the semiconductor layer 600 may be connected with the SD device, and the SD device may be electrically connected with the at least one first gate layer 211 and the at least one second gate layer 221 through the first connection structure 230.

It is to be noted that, the first connection structure 230 being connected with the at least one first gate layer 211 may be understood as that the first connection structure 230 may be connected with one first gate layer 211 or may be connected with a plurality of first gate layers 211. The first connection structure 230 being connected with the at least one second gate layer 221 may be understood as that the first connection structure 230 may be connected with one second gate layer 221 or may be connected with a plurality of second gate layers 221. In the present example, explanation is made by taking a case in which the first connection structure 230 is connected with one first gate layer 211 and the first connection structure 230 is connected with one second gate layer 221 as an example.

In some other examples, referring to Figs. 4, 8 and 9, one first gate layer 211 is connected with one SD device through one gate line contact G-CNT, and one second gate layer 221 is connected with one SD device through one gate line contact G-CNT. There are many gate line contacts G-CNT and SD devices and a plurality of gate line contacts G-CNT are arranged in a staircase pattern, which results in a large area occupied by the gate line contacts G-CNT and SD devices, thus being disadvantage for improving memory density of memory devices 10.

While in the present example, referring to Figs. 8 and 9, one first gate layer 211 and one second gate layer 221 may share one first connection structure 230 and share one SD device. Then, when the memory device 10 has two stack structures, namely the first stack structure 210 and the second stack structure 220, as compared to the case in which one first gate layer 211 is connected with one SD device through one gate line contact G-CNT and one second gate layer 221 is connected with one SD device through one gate line contact G-CNT, in the present example, the number of the first connection structures 230 is smaller than the number of the gate line contacts G-CNT, and the number of the SD devices in the present example is also relatively small. Therefore, the area occupied by the first connection structures 230 is smaller than the area occupied by the gate line contacts G-CNT, while the area occupied by the SD devices is also reduced, which facilitates improving the memory density of memory devices 10.

When the memory device 10 includes more stack structures, for example, 4, 6 or 8 stack structures, the first connection structure 230 may be connected with one gate layer in each stack structure of the plurality of stack structures. With the above-described arrangement, even more stack structures are added, the number of first connection structures 230 will not increase, that is, the area occupied by the first connection structures 230 is not increased, which facilitates improving memory density of the memory device 10 and facilitates the development of the memory device 10 towards large capacity and small volume.

In addition, as described above, in the art, in order to improve a capacity of the memory device 10, the number of stack structures is increased, and the number of SD devices is increased accordingly, and in order to control the size of the memory device 10, the problem of shrinking the size of the SD device needs to be addressed. With the present example in which a first connection structure 230 is connected with one gate layer in each stack structure of the plurality of stack structures, the number of SD devices will not be increased, and therefore it is possible to mitigate the requirement of shrinking the size of SD device.

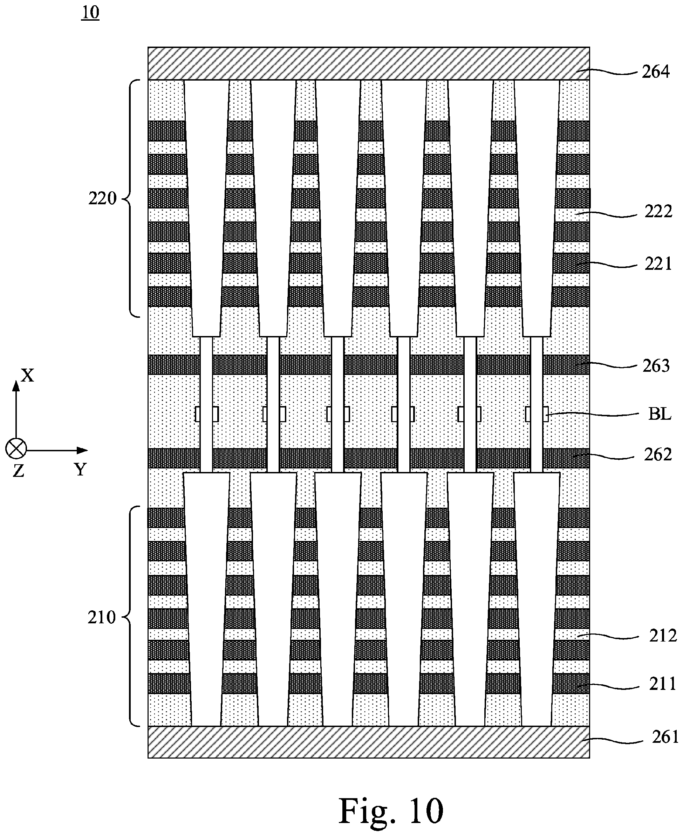

In the present example, as shown in Figs. 9 and 10, the bit line BL is located between the first stack structure 210 and the second stack structure 220, and the bit line BL has an extending direction intersecting the first direction X. It is appreciated that the bit line BL may extend in the Y-Z plane. For example, the extending direction of the bit line BL may be parallel to the third direction Z. The number of bit lines BL is plurality, and the plurality of bit lines BL are arranged at intervals in the second direction Y. As shown in Fig. 10, the bit line BL is connected with the channel structure in the first stack structure 210 and also connected with the channel structure in the second stack structure 220. With the above-described arrangement, the bit line BL is located between the first stack structure 210 and the second stack structure 220, and the bit line BL may drive upwardly the channel structure in the first stack structure 210 while driving downwardly the channel structure in the second stack structure 220. In some other examples, when the bit line BL is located at the topmost end of the plurality of stack structures (in the present example, the end of the second stack structure 220 away from the first stack structure 210), since a resistance is present in the channel structure, the current intensity in the channel structure being away from the bit line BL is weak. As compared to the scheme in which the bit line BL is located at the topmost end of the plurality of stack structures, in the present example, the bit line BL is located between the first stack structure 210 and the second stack structure 220, which facilitates improving the current intensity in the channel structure, thereby mitigating the problem of weak current intensity in the channel structure being away from the bit line BL.

In some examples, as shown in Fig. 9, the first connection structure 230 includes a first connection sub-section 231 and a second connection sub-section 232 stacked in the first direction X. The first connection sub-section 231 includes a first connection pillar 2311 and at least one first connection layer 2312. The first connection pillar 2311 extends in the first direction X. The first connection layer 2312 is parallel to the second direction Y. One first connection layer 2312 connects the first connection pillar 2311 and one first gate layer 211.

Illustratively, in the Y-Z plane, the first connection layer 2312 may surround and be connected with the first connection pillar 2311. The first connection pillar 2311 may be disposed integrally with the first connection layer 2312. The first connection layer 2312 may be located on the same horizontal plane (Y-Z plane) as one first gate layer 211 to facilitate connecting the first connection layer 2312 and one first gate layer 211.

It is to be noted that the first connection sub-section 231 includes at least one first connection layer 2312, which may be understood as the first connection sub-section 231 may include one first connection layer 2312 or the first connection sub-section 231 may include a plurality of first connection layers 2312. When the first connection sub-section 231 includes the plurality of first connection layers 2312, the plurality of first connection layers 2312 may be arranged at intervals along the first direction X. In the present example, explanation is made by taking a case in which the first connection sub-section 231 includes one first connection layer 2312 as an example.

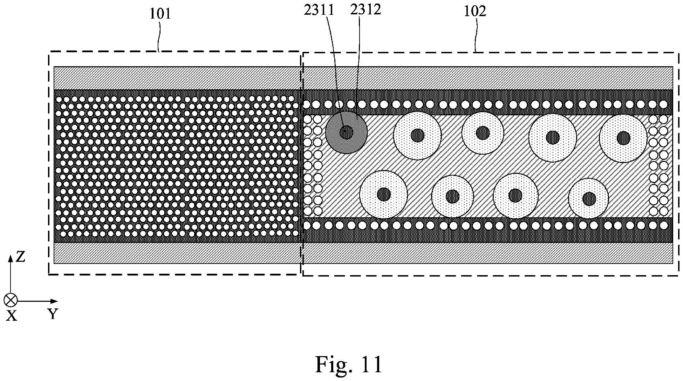

Referring to Fig. 11, in the Y-Z plane, the cross section of the first connection pillar 2311 may be for example circular, the cross section of the first connection layer 2312 may be for example a ring, and the first connection layer 2312 may surround the first connection pillar 2311 and the first connection layer 2312 is connected with the first connection pillar 2311.

The second connection sub-section 232 includes a second connection pillar 2321 and at least one second connection layer 2322. The second connection pillar 2321 extends in the first direction X and is connected with the first connection pillar 2311. The second connection layer 2322 is parallel to the second direction Y, and one second connection layer 2322 connects the second connection pillar 2321 and one second gate layer 221.

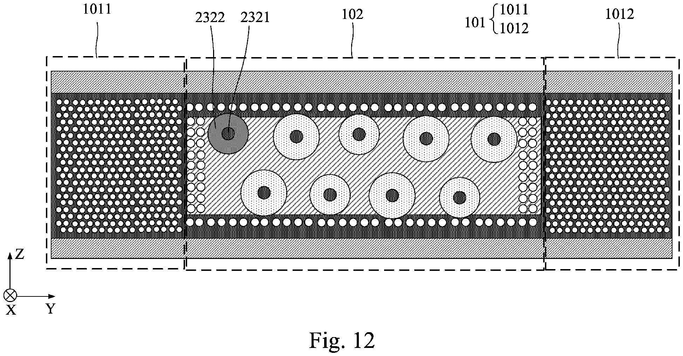

Illustratively, referring to Figs. 9 and 12, in the Y-Z plane, the second connection layer 2322 may surround and be connected with the second connection pillar 2321. The second connection pillar 2321 is connected with the first connection pillar 2311, then the first connection pillar 2311, the first connection layer 2312, the second connection pillar 2321 and the second connection layer 2322 may be disposed integrally. The second connection layer 2322 may be located on the same horizontal plane (the Y-Z plane) as one second gate layer 221 to facilitate connecting the second connection layer 2322 and the one second gate layer 221.

It is to be noted that the second connection sub-section 232 includes at least one second connection layer 2322, which may be understood as the second connection sub-section 232 may include one second connection layer 2322 or the second connection sub-section 232 may include a plurality of second connection layers 2322. When the second connection sub-section 232 includes the plurality of second connection layers 2322, the plurality of second connection layers 2322 may be arranged at intervals along the first direction X. In the present example, explanation is made by taking a case in which the first connection sub-section 231 including one first connection layer 2312 as an example.

Referring to Fig. 12, in the Y-Z plane, the cross section of the second connection pillar 2321 may be for example circular, the cross section of the second connection layer 2322 may be for example a ring, the second connection layer 2322 may surround the second connection pillar 2321 and the second connection layer 2322 is connected with the second connection pillar 2321.

With the above-described arrangement, the end of the second connection pillar 2321 away from the first connection pillar 2311 may be connected with the SD device, then one SD device may be connected with the at least one second gate layer 221 through the second connection pillar 2321 and the second connection layer 2322, and the SD device may be connected with the at least one first gate layer 211 through the first connection pillar 2311 and the first connection layer 2312. It is appreciated that gate layers in different stack structures may share one first connection structure 230 and one SD device, which facilitates improving memory density of the memory device 10.

In some examples, as shown in Fig. 9, the first connection sub-section 231 and the second connection sub-section 232 are an integral structure. The constituting materials for the first connection sub-section 231 and the second connection sub-section 232 may be the same. It is appreciated that the first connection sub-section 231 and the second connection sub-section 232 may be made in one process step. With the above-described arrangement, the first connection sub-section 231 and the second connection sub-section 232 are an integral structure, which facilitates the electrical connection between the first connection sub-section 231 and the second connection sub-section 232 and improving the stability of the memory device 10.

In some examples, as shown in Fig. 9, in the second direction Y, the size of the end of the first connection pillar 2311 close to the second connection pillar 2321 is greater than the size of the end of the second connection pillar 2321 close to the first connection pillar 2311. Illustratively, in the X-Y plane, the cross-sectional shape of the first connection pillar 2311 may be a rectangle, and the cross-sectional shape of the second connection pillar 2321 may also be a rectangle. In the second direction Y, the width of the first connection pillar 2311 is greater than the width of the second connection pillar 2321. Alternatively, in the X-Y plane, the cross-sectional shape of the first connection pillar 2311 may be an inverted trapezoidal with a wide top and a narrow bottom, and the cross-sectional shape of the second connection pillar 2321 may also be an inverted trapezoidal with a wide top and a narrow bottom. In the X-Y plane, a size of the topline of the first connection pillar 2311 is greater than a size of the baseline of the second connection pillar 2321.

In the present example, in the plane in which the first connection pillar 2311 contacts the second connection pillar 2321, in the second direction Y, a width of the first connection pillar 2311 is greater than a width of the second connection pillar 2321. In addition, in the plane in which the first connection pillar 2311 contacts the second connection pillar 2321, in the second direction Y, the first connection pillar 2311 may completely overlap the second connection pillar 2321, that is, the edges of two sides of the second connection pillar 2321 may be both within the edges of two sides of the first connection pillar 2311; or the first connection pillar 2311 may partially overlap with the second connection pillar 2321, that is, an edge of one side of the second connection pillar 2321 may be outside of an edge of one side of the first connection pillar 2311.

The above-described arrangement facilitates improving a process window for implementing contact connection between the second connection pillar 2321 and the first connection pillar 2311 to facilitate connection between the second connection pillar 2321 and the first connection pillar 2311, improve stability of connection between the second connection pillar 2321 and the first connection pillar 2311, and in turn improve the memory stability of the memory device 10.

In some examples, as shown in Fig. 9, in the second direction Y, the size of the end of the first connection pillar 2311 close to the second connection pillar 2321 is greater than the size of the end of the first connection pillar 2311 away from the second connection pillar 2321. As shown in Fig. 9, in the Y-Z plane, the cross-sectional shape of the first connection pillar 2311 may be an inverted trapezoidal with a wide top and a narrow bottom, and in the second direction Y, the width of topline of the cross-section of the first connection pillar 2311 is greater than the width of the baseline of the cross-section of the first connection pillar 2311.

In addition, in the second direction Y, the size of the end of the second connection pillar 2321 away from the first connection pillar 2311 is greater than the size of the end of the second connection pillar 2321 close to the first connection pillar 2311. As shown in Fig. 9, in the Y-Z plane, the cross-sectional shape of the second connection pillar 2321 may be an inverted trapezoidal with a wide top and a narrow bottom, and in the second direction Y, the width of topline of the cross-section of the second connection pillar 2321 is greater than the width of the baseline of the cross-section of the second connection pillar 2321. In the Y-Z plane, the baseline of the cross section of the second connection pillar 2321 contacts the topline of the cross section of the first connection pillar 2311, thereby realizing electrical connection between the first connection pillar 2311 and the second connection pillar 2321.

The above-described arrangement facilitates improving the process window for implementing contact connection between the second connection pillar 2321 and the first connection pillar 2311 to facilitate the connection between the second connection pillar 2321 and the first connection pillar 2311, improve stability of the connection between the second connection pillar 2321 and the first connection pillar 2311, and in turn improve the memory stability of the memory device 10.

In some examples, as shown in Fig. 9, the first connection structure 230 further includes a first isolation layer 233 and a second isolation layer 234. The first isolation layer 233 is located on a side of the first connection layer 2312 close to the second connection layer 2322, and the first isolation layer 233 surrounds the first connection pillar 2311. For example, the first isolation layer 233 may cover perimeter surfaces of the first connection pillar 2311 to isolate the first connection pillar 2311 and prevent leak current from being generated between the first connection pillar 2311 and other conductive structures, thus facilitating improving memory stability of the memory device 10.

Also, the second isolation layer 234 is located on a side of the second connection layer 2322 away from the first connection layer 2312, and the second isolation layer 234 surrounds the second connection pillar 2321. For example, the second isolation layer 234 may cover perimeter surfaces of the second connection pillar 2321 to isolate the second connection pillar 2321 and prevent leak current from being generated between the second connection pillar 2321 and other conductive structures, thus facilitating improving memory stability of the memory device 10.

In some examples, as shown in Fig. 9, a size of the end of the first isolation layer 233 away from the first connection layer 2312 and in the second direction is greater than a size of the end of the first isolation layer 233 close to the first connection layer 2312 and in the second direction. In the second direction Y, the first isolation layer 233 has a thickness, and a thickness of the end of the first isolation layer 233 close to the second connection pillar 2321 may be greater than a thickness of the end of the first isolation layer 233 close to the first connection layer 2312. Thus, it is beneficial to further improve the isolation effect on the end of the first connection pillar 2311 close to the second connection pillar 2321.

Referring back to Fig. 9, in the second direction Y, the second isolation layer 234 has a thickness, and a thickness of the end of the second isolation layer 234 away from the first connection pillar 2311 may be greater than a thickness of the end of the second isolation layer 234 close to the first connection pillar 2311. Thus, it is beneficial to further improve the isolation effect of the second isolation layer 234 on the end of the second connection pillar 2321 away from the first connection pillar 2311.

In some examples, as shown in Fig. 9, the first connection structure 230 further includes a third isolation layer 235 and a fourth isolation layer 236.

The third isolation layer 235 is located on a side of the first connection layer 2312 away from the first isolation layer 233, contacts the first connection pillar 2311 and surrounds the first connection pillar 2311. It may be understood as that the first isolation layer 233 is located over the first connection layer 2312 and surrounds the first connection pillar 2311 to isolate the first connection pillar 2311 over the first connection layer 2312; and the third isolation layer 235 is located under the first connection layer 2312 and surrounds the first connection pillar 2311 to isolate the first connection pillar 2311 under the first connection layer 2312. Both the first isolation layer 233 and the third isolation layer 235 contact the first connection pillar 2311.

The fourth isolation layer 236 is located on a side of the second connection layer 2322 away from the second isolation layer 234, contacts the second connection pillar 2321 and surrounds the second connection pillar 2321. It may be understood as that the second isolation layer 234 is located over the second connection layer 2322 and surrounds the second connection pillar 2321 to isolate the second connection pillar 2321 over the second connection layer 2322; and the fourth isolation layer 236 is located under the second connection layer 2322 and surrounds the second connection pillar 2321 to isolate the second connection pillar 2321 under the second connection layer 2322. Both the second isolation layer 234 and the fourth isolation layer 236 contact the second connection pillar 2321.

Providing the third isolation layer 235 facilitates isolating the first connection pillar 2311 and prevents leak current from being generated between the first connection pillar 2311 and other conductive structures, thus facilitating improving memory stability of the memory device 10. Providing the fourth isolation layer 236 facilitates isolating the second connection pillar 2321 and prevents leak current from being generated between the second connection pillar 2321 and other conductive structures, thus facilitating improving memory stability of the memory device 10.

In some examples, as shown in Fig. 9, the first connection layer 2312 includes a first sub-layer 3121 and a second sub-layer 3122 stacked in the first direction X. The first sub-layer 3121 is located between the first isolation layer 233 and the second sub-layer 3122 and the first isolation layer 233 surrounds the first sub-layer 3121. Both the first sub-layer 3121 and the second sub-layer 3122 surround the first connection pillar 2311 and contact the first connection pillar 2311. The first sub-layer 3121 and the second sub-layer 3122 are stacked in the first direction X and contact each other. Then, the first sub-layer 3121 is electrically connected with the first connection pillar 2311, the second sub-layer 3122 is electrically connected with the first connection pillar 2311, and the first sub-layer 3121 and the second sub-layer 3122 are electrically connected. The first connection layer 2312 is connected with the first connection pillar 2311 through the first sub-layer 3121 and the second sub-layer 3122, which facilitates improving stability of electrical connection between the first connection layer 2312 and the first connection pillar 2311.

Illustratively, in the first direction X, the size of the first sub-layer 3121 may be greater than the size of the second sub-layer 3122 such that it is possible to increase the contact area between the first sub-layer 3121 and the first connection pillar 2311, which facilitates further improving the stability of electrical connection between the first connection layer 2312 and the first connection pillar 2311.

In addition, the first isolation layer 233 may surround the first sub-layer 3121 to in turn prevent leak current from being generated between the first sub-layer 3121 and other conductive structures, thus facilitating improving the memory stability of the memory device 10.

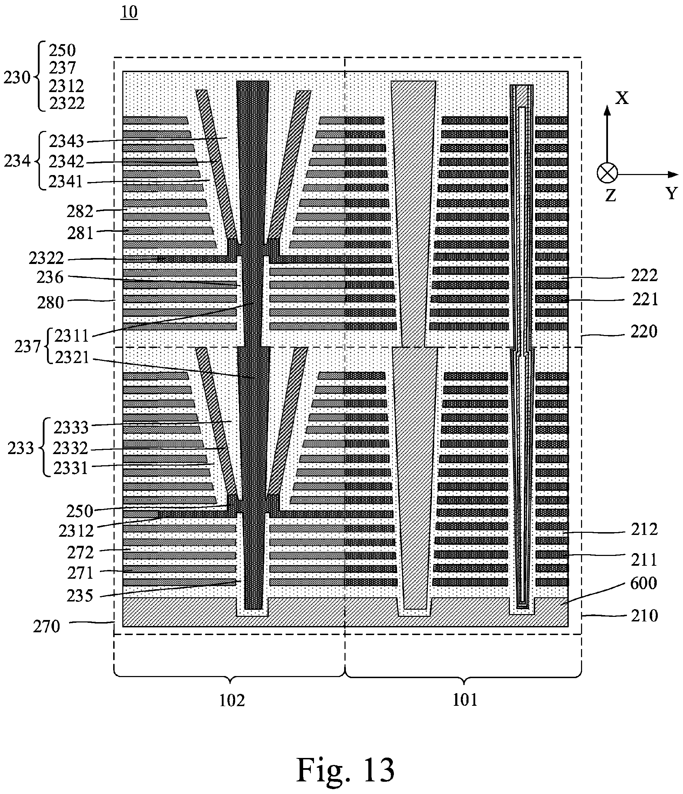

In some examples, as shown in Fig. 13, the memory device 10 further includes a third connection layer 250. The third connection layer 250 surrounds the connection pillar and is connected with the first connection pillar 2311. In the first direction X, an edge of the third connection layer 250 on a side away from the first isolation layer 233 is connected with the first connection layer 2312. The first connection layer 2312 surrounds the third connection layer 250 and is connected with the first gate layer 211.

Referring to Fig. 13, the first connection layer 2312 is for example of a ring structure. A portion of outer edge of the first connection layer 2312 may be connected with the first gate layer 211 and the inner edge of the first connection layer 2312 may be connected with the third connection layer 250. The third connection layer 250 may surround the first connection pillar 2311 and contact the first connection pillar 2311, thereby implementing electrical connection. With the above-described arrangement, the first connection layer 2312 may be electrically connected with the first connection pillar 2311 through the third connection layer 250, thereby implementing signal transfer.

In some examples, as shown in Fig. 13, the first isolation layer 233 includes a first sub isolation layer 2331, a second sub isolation layer 2332 and a third sub isolation layer 2333. The first sub isolation layer 2331 surrounds the connection pillar. The second sub isolation layer 2332 is located between the first sub isolation layer 2331 and the connection pillar and surrounds the connection pillar. The third sub isolation layer 2333 is located between the second sub isolation layer 2332 and the connection pillar and surrounds the connection pillar.

Illustratively, the constituting materials for the first sub isolation layer 2331, the second sub isolation layer 2332 and the third sub isolation layer 2333 may be insulating materials. The insulating materials are for example a combination of one or more of silicon oxide, silicon nitride and high dielectric constant insulating material, and may also be other insulating materials. The constituting materials for the first sub isolation layer 2331, the second sub isolation layer 2332 and the third sub isolation layer 2333 may be the same or different, which is not limited in the present disclosure.

With the above-described arrangement, the first sub isolation layer 2331, the second sub isolation layer 2332 and the third sub isolation layer 2333 together isolate the first connection pillar 2311 located on the side of the first connection layer 2312 close to the second connection layer 2322, which facilitates enhancing the isolation effect of the first isolation layer 233 on the first connection pillar 2311, and in turn prevents leak current from being generated between the first sub-layer 3121 and other conductive structures, facilitating improving memory stability of the memory device 10.

In some examples, as shown in Fig. 13, the edge on the side of the third connection layer 250 close to the second sub isolation layer 2332 extends toward a direction close to the second sub isolation layer 2332. That is, the edge on the side of the third connection layer 250 close to the second sub isolation layer 2332 may extend upwardly to between the first sub isolation layer 2331 and the third sub isolation layer 2333, thereby enhancing the connection force between the third connection layer 250 and the first isolation layer 233 and facilitating improving structure stability of the memory device 10.

In the present example, the first sub isolation layer 2331 may surround the third connection layer 250 to in turn prevent leak current from being generated between the third connection layer 250 and other conductive structures, facilitating improving memory stability of the memory device 10.

In some examples, as shown in Fig. 10, the memory device 10 further includes a first select gate 261, a second select gate 262, a third select gate 263 and a fourth select gate 264. The first select gate 261 is located on the side of the first stack structure 210 away from the second stack structure 220. The second select gate 262 is located on the side of the first stack structure 210 close to the second stack structure 220. The third select gate 263 is located on the side of the second stack structure 220 close to the first stack structure 210. The bit line BL connects the second select gate 262 and the third select gate 263. The fourth select gate 264 is located on the side of the second stack structure 220 away from the first stack structure 210.

Referring to Fig. 10, the bit line BL is located between and connects the second select gate 262 and the third select gate 263. With the above-described arrangement, when the bit line BL is turned on, the first select gate 261 and the second select gate 262 may be turned on. Further, the bit line BL may drive upwardly the channel structure in the first stack structure 210 and drive downwardly the channel structure in the second stack structure 220 at the same time. The above-described arrangement facilitates improving current intensity in the channel structure, thereby mitigating the problem of weak current intensity in the channel structure away from bit line BL.

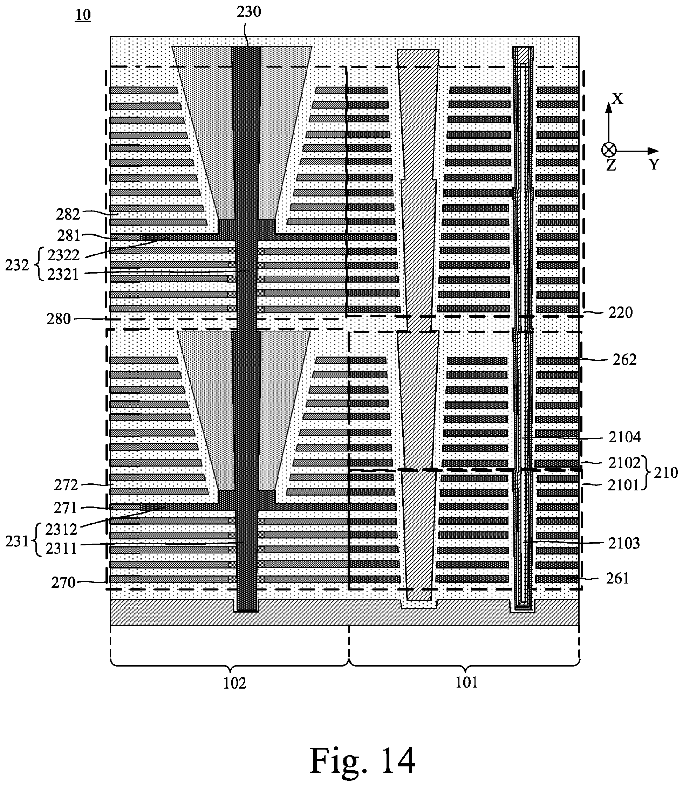

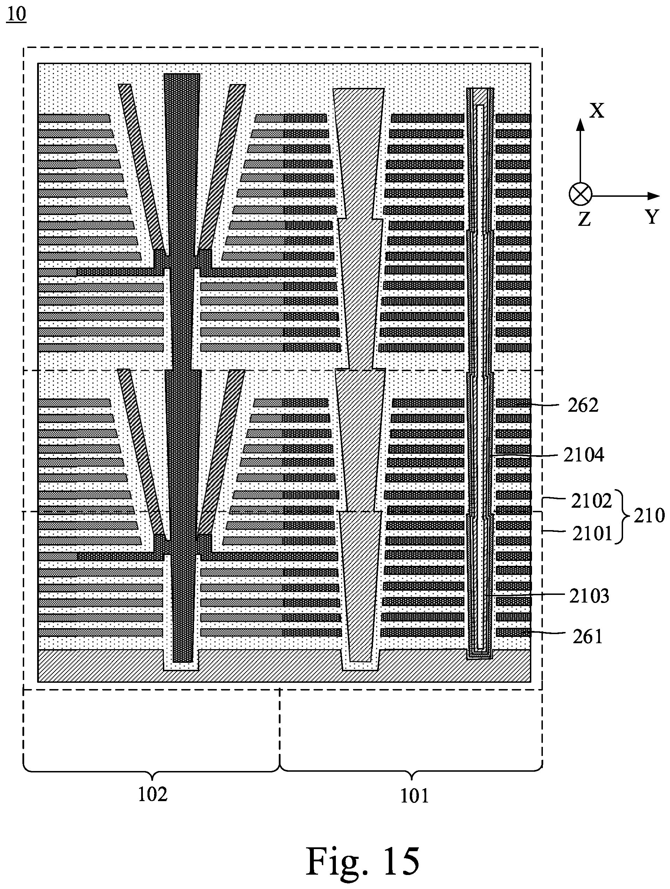

In some examples, as shown in Figs. 14 and 15, the first stack structure 210 includes a first sub stack structure 2101 and a second sub stack structure 2102 stacked in the first direction X, a first channel structure 2103 and a second channel structure 2104. The first channel structure 2103 extends through the first sub stack structure 2101 and the second channel structure 2104 extends through the second sub stack structure 2102. The first channel structure 2103 is located between the first select gate 261 and the second select gate 262.

In the present example, as shown in Figs. 14 and 15, the first stack structure 210 may include a first sub stack structure 2101 and a second sub stack structure 2102 stacked in the first direction X, which may be understood as the first stack structure 210 may include a plurality of sub stack structures, for example, the first stack structure 210 may include, but not limited to 2 sub stack structures, 4 sub stack structures or 8 sub stack structures etc. thereby improving a memory capacity of the memory device 10. In addition, the first sub stack structure 2101 and the second sub stack structure 2102 are stacked in the first direction X, facilitating improving the memory density of the memory device 10. The present example is explained by taking a case in which the first stack structure 210 includes 2 sub stack structures as an example.

Referring again to Figs. 14 and 15, the first channel structure 2103 extends through the first sub stack structure 2101 and the second channel structure 2104 extends through the second sub stack structure 2102. Illustratively, the first channel structure 2103 and the second channel structure 2104 may be in communication to improve the memory capacity of the memory device 10. Among the plurality of first gate layers 211 surrounding the first channel structure 2103, the first gate layer 211 that is farthest from the second channel structure 2104 may be configured as the first select gate 261. Among the plurality of first gate layers 211 surrounding the second channel structure 2104, the first gate layer 211 that is farthest from the first channel structure 2103 may be configured as the second select gate 262. Then, the first channel structure 2103 and the second channel structure 2104 are located between the first select gate 261 and the second select gate 262, which facilitates the memory device 10 to perform read and write operations on the first channel structure 2103 and the second channel structure 2104.

In some examples, as shown in Figs. 11 and 12, the memory device 10 includes a first region 101 and a second region 102, the first region 101 adjoining the second region 102. Both the first stack structure 210 and the second stack structure 220 are located in the first region 101, and the first connection structure 230 is located in the second region 102, the second region 102 being located on a side of the first region 101. As an example, in Fig. 11, in the second direction Y, the second region 102 is located on a side of the first region 101, and the first region 101 and the second region 102 adjoin each other on only one side.

Alternatively, in some other examples, as shown in Fig. 12, the first region 101 includes a first sub-region 1011 and a second sub-region 1012, and the second region 102 is located between the first sub-region 1011 and the second sub-region 1012.

With the above-described arrangement, the first connection structure 230 in the second region 102 may be connected with one first gate layer 211 and with one second gate layer 221. As compared to the manner shown in Fig. 4 in which the gate line contacts G-CNT arranged in a staircase pattern pad out the first gate layer 211 and the second gate layer 221 one by one, in the present example, the one first gate layer 211 and the one second gate layer 221 share one first connection structure 230, which facilitates controlling the area of the second region 102 and in turn improving the memory density of the memory device 10.

In some examples, as shown in Fig. 13, the memory device 10 further includes a third stack structure 270 and a fourth stack structure 280 stacked in the first direction X, both of which are located in the second region 102. A relatively thick dielectric layer may be disposed between the third stack structure 270 and the fourth stack structure 280.

The first connection pillar 2311 extends through the third stack structure 270 that includes a plurality of third dielectric layers 271 and a plurality of fourth dielectric layers 272 stacked alternatively in the first direction X. At least one third dielectric layer 271 is connected with at least one first connection layer 2312. Here, the first connection layer 2312 connected with the third dielectric layer 271 may be connected with one first gate layer 211.

The second connection pillar 2321 extends through the fourth stack structure 280 that includes a plurality of fifth dielectric layers 281 and a plurality of sixth dielectric layers 282 stacked alternatively in the first direction X. At least one fifth dielectric layer 281 is connected with at least one second connection layer 2322. Here, the second connection layer 2322 connected with the fifth dielectric layer 281 may be connected with one second gate layer 221.

Illustratively, the third dielectric layer 271 may be connected with the first gate layer 211 and the fourth dielectric layer 272 may be connected with the first dielectric layer 212. In addition, the fourth dielectric layer 272 may have the same constituting material as the first dielectric layer 212. Further, the fourth dielectric layer 272 may be disposed in the same layer as the first dielectric layer 212. Being disposed in the same layer means a plurality of patterns are on the same pattern layer. A pattern layer refers to a film layer formed by one patterning process. The patterning process refers to a process capable of forming at least one pattern with a certain shape. For example, a thin film is formed on a substrate by any one of a variety of film forming processes such as deposition, coating and sputtering, and then the thin film is patterned to form a film layer including at least one pattern, which is referred to as a pattern layer. The operation of patterning includes coating photoresist, exposure, development, etching and stripping photoresist, etc. In the present example, the position relationship of a plurality of patterns belonging to the same pattern layer is referred to as being disposed in the same layer.

Illustratively, the fifth dielectric layer 281 may be connected with the second gate layer 221 and the sixth dielectric layer 282 may be connected with the second dielectric layer 222. In addition, the sixth dielectric layer 282 may have the same constituting material as the second dielectric layer 222. Further, the sixth dielectric layer 282 may be disposed in the same layer as the second dielectric layer 222.

In the present example, the constituting materials for the first dielectric layer 212, the second dielectric layer 222, the fourth dielectric layer 272 and the sixth dielectric layer 282 are oxides, and the constituting materials for the third dielectric layer 271 and the fifth dielectric layer 281 are nitrides.

In some examples, referring to Figs. 8, 10 and 11, the memory device further includes a second connection structure 240. The second connection structure 240 is located on a side of the first stack structure 210 and the second stack structure 220 in the second direction. For example, in Fig. 11, both the first stack structure 210 and the second stack structure 220 may be located in the second region 102, and the second connection structure 240 may be located in the first region 101. One of the first select gate 261 and the second select gate 262 is connected with the second connection structure 240. That is, the second connection structure 240 is connected with the first select gate 261, or the second connection structure 240 is connected with the second select gate 262.

In some other examples, referring to Figs. 8 and 10, one of the third select gate 263 and the fourth select gate 264 is connected with the second connection structure 240. That is, the second connection structure 240 is connected with the third select gate 263, or the second connection structure 240 is connected with the fourth select gate 264.

With the above-described arrangement, the memory device 10 may choose to turn on the channel structure in the first stack structure 210 or the channel structure in the second stack structure 220 through the second connection structure 240, and then further choose to read from or write to memory nodes in the first stack structure 210 or the second stack structure 220 through the first connection structure 230 and the bit line BL.

Illustratively, the number of the second connection structures 240 may be plurality. For example, one second connection structure 240 connected with the first select gate 261, one second connection structure 240 connected with the second select gate 262, one second connection structure 240 connected with the third select gate 263, and one second connection structure 240 connected with the fourth select gate 261 are disposed. Thus, a plurality of second connection structures 240 is disposed. When a certain second connection structure 240 is in poor connection, it is possible to select the first stack structure 210 and the second stack structure 220 through other second connection structures 240, thus facilitating improving the memory stability of the memory device 10.

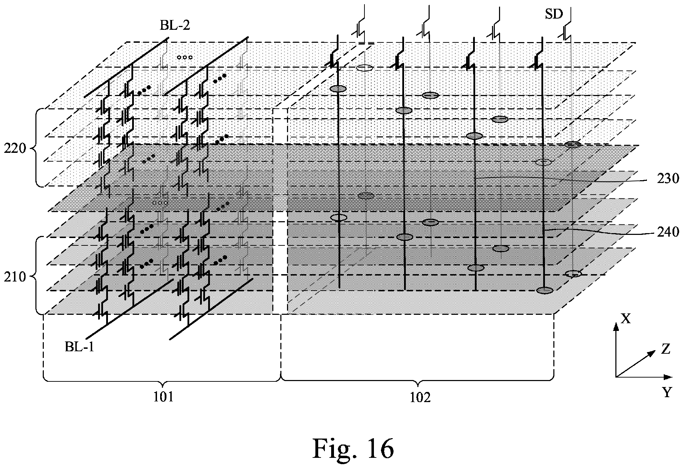

Referring to Figs. 13 and 16, some examples of the present disclosure further provide a memory device 10 including a first stack structure 210, a second stack structure 220 and a first connection structure 230. The first stack structure 210 includes a plurality of first gate layers 211 and a plurality of first dielectric layers 212 stacked alternatively in the first direction X. The second stack structure 220 includes a plurality of second gate layers 221 and a plurality of second dielectric layers 222 stacked alternatively in the first direction X. The second stack structure 220 and the first stack structure 210 are stacked in the first direction X.

The first stack structure 210 may be disposed on the semiconductor layer 600. Illustratively, the first stack structure 210 may be in direct contact with the semiconductor layer 600. Illustratively, the constituting material for semiconductor layer 600 may include for example single crystalline silicon, single-crystalline germanium, III-V compound semiconductor materials, II-V compound and other suitable semiconductor materials.

It is to be noted that the explanation of the first stack structure 210 and the second stack structure 220 in the above examples may be referred to for the first stack structure 210 and the second stack structure 220 in the present example, which will not be described any more herein.

As shown in Fig. 13, the first connection structure 230 includes: a connection pillar 237, at least one first connection layer 2312 and at least one second connection layer 2322. The connection pillar 237 is located on a side of the first stack structure 210 and the second stack structure 220 in the second direction Y. The first connection layer 2312 is parallel to the second direction Y and one first connection layer 2312 connects one first gate layer 211 and the connection pillar 237. The second connection layer 2322 is parallel to the second direction Y and one second connection layer 2322 connects one second gate layer 221 and the connection pillar 237.

It is to be noted that the explanation for the first connection structure 230 in the above examples may be referred to for the constituting material for the first connection structure 230 in the present example.

In the present example, the first connection structure 230 may include one first connection layer 2312 or a plurality of first connection layers 2312, and the first connection structure 230 may include one second connection layer 2322 or a plurality of second connection layers 2322. Illustration will be given below by taking a case in which the first connection structure 230 includes one first connection layer 2312 and one second connection layer 2322 as an example.

With the above-described arrangement, the first connection layer 2312 in the first connection structure 230 is connected with the first gate layer 211 in the first stack structure 210, the second connection layer 2322 in the first connection structure 230 is connected with the second gate layer 221 in the second stack structure 220, and the connection pillar is connected with the SD device. As compared to Fig. 4, one first gate layer 211 is connected with the SD device through one gate line contact G-CNT, one second gate layer 221 is connected with the SD device through one gate line contact G-CNT, and a plurality of gate line contacts G-CNT are arranged in a staircase pattern, which results in a large area occupied by the plurality of gate line contacts G-CNT. In the present example, the number of the first connection structures 230 is smaller than the number of the gate line contacts G-CNT, and the number of the SD devices in the present example is also relatively small. Therefore, the area occupied by the first connection structures 230 is smaller than the area occupied by the gate line contacts G-CNT, and at the same time the area occupied by the SD devices is reduced, which facilitates improving the memory density of memory devices 10.

When the memory device 10 includes more stack structures, for example, the memory device 10 may include 4, 6 or 8 stack structures, at this time, the first connection structure 230 may be connected with one gate layer in each stack structure of the plurality of stack structures. With the above-described arrangement, even more stack structures are added, the number of first connection structures 230 will not increase, that is, the area occupied by the first connection structures 230 is not increased, which facilitates improving memory density of the memory device 10 and facilitates the development of the memory device 10 towards large capacity and small volume.

In addition, as described above, in the art, in order to improve the capacity of the memory device 10, the number of stack structures is increased, and the number of the SD devices is increased accordingly, and in order to control the size of the memory device 10, the problem of shrinking the size of the SD device needs to be addressed. With the present example in which the first connection structure 230 is connected with one gate layer in each stack structure of the plurality of stack structures, the number of the SD devices will not be increased, and therefore it is possible to mitigate the requirement of shrinking the size of the SD device.

In some examples, as shown in Figs. 10 and 16, the memory device 10 further includes a first select gate 261, a second select gate 262, a third select gate 263, a fourth select gate 264 and a second connection structure 240. The first select gate 261 is located on a side of the first stack structure 210 away from the second stack structure 220, the second select gate 262 is located on a side of the first stack structure 210 close to the second stack structure 220, the third select gate 263 is located on a side of the second stack structure 220 close to the first stack structure 210, and the fourth select gate 264 is located on a side of the second stack structure 220 away from the first stack structure 210.

The second connection structure 240 is located on a side of the first stack structure 210 and the second stack structure 220 in the second direction. The second connection structure 240 and the first connection structure 230 may be located on the same side of the first stack structure 210 and the second stack structure 220. One of the first select gate 261, the second select gate 262, the third select gate 263 and the fourth select gate 264 is connected with the second connection structure 240.

With the above-described arrangement, the memory device 10 may choose to turn on the channel structure in the first stack structure 210 or the channel structure in the second stack structure 220 through the second connection structure 240 and then further choose to read or write memory nodes in the first stack structure 210 or the second stack structure 220 through the first connection structure 230 and the bit line BL.

In some examples, as shown in Fig. 16, the memory device 10 further includes a first bit line BL-1 and a second bit line BL-2. The first bit line BL-1 is located on a side of the first select gate 261 away from the first stack structure 210, and the second bit line BL-2 is located on a side of the fourth select gate 264 away from the first stack structure 210. the first bit line BL-1 and the second bit line BL-2 have an extending direction intersecting the first direction X. The extending direction of the first bit line BL-1 and the second bit line BL-2 may be parallel.

It is to be noted that when a plurality of stack structures is further stacked in the memory device 10, the first bit line BL-1 and the second bit line BL-2 are located on two sides of all the stack structures in the first direction X and active layers are disposed between adjacent stack structures.

In the present example, an active layer may be disposed between the first stack structure 210 and the second stack structure 220, such as by depositing silicon material, wherein the first dielectric layer 212 in the first stack structure 210 contacts a side of the active layer and the second dielectric layer 222 in the second stack structure 220 contacts the other side of the active layer. The channel structure in the first stack structure 210 may extend through the first stack structure 210 and a portion of the active layer, the channel structure in the second stack structure 220 may extend through the second stack structure 220 and a portion of the active layer, and the channel structure in the first stack structure 210 is in communication with the channel structure in the second stack structure 220.

With the above-described arrangement, the first bit line BL-1, the channel structure in the first stack structure 210, the channel structure in the second stack structure 220 and the second bit line BL-2 are in communication with each other, then the channel structures in the first stack structure 210 and the second stack structure 220 may be driven through the first bit line BL-1 and the second bit line BL-2. As compared to the approach in which the bit line BL is located at the topmost end of the plurality of stack structures, in the present example, the bit line BL is located between the first stack structure 210 and the second stack structure 220, which facilitates improving the current intensity in channel structures, thereby mitigating the problem of weak current intensity in the channel structure away from the bit line BL.

In some examples, as shown in Fig. 11, the memory device 10 includes a first region 101 and a second region 102, the first region 101 and the second region 102 adjoining each other in the second direction Y. Both the first stack structure 210 and the second stack structure 220 are located in the first region 101, the first connection structure 230 is located in the second region 102. Illustratively, in the second direction Y, the second region 102 is located on a side of the first region 101 and either the first region 101 or the second region 102 are adjacent on only one side. In some examples, the second connection structure 240 is also located in the second region 102.

Alternatively, in some other examples, the first region 101 includes a first sub-region 1011 and a second sub-region 1012, and the second region 102 is located between the first sub-region 1011 and the second sub-region 1012.

With the above-described arrangement, the first connection structure 230 in the second region 102 may be connected with one first gate layer 211 and with one second gate layer 221. As compared to the approach as shown in Fig. 4 in which the gate line contacts G-CNT arranged in a staircase pattern lead out the first gate layers 211 and the second gate layers 221 one by one, in the present example, one first gate layer 211 and one second gate layer 221 share one first connection structure 230, which facilitates controlling the area of the second region 102 and in turn improving the memory density of the memory device 10.

In the present example, the memory device 10 may further include a third stack structure 270 and a fourth stack structure 280 stacked in the first direction X, both of which are located in the second region 102. The connection pillar may extend through the third stack structure 270 and the fourth stack structure 280. The explanation for the third stack structure 270 and the fourth stack structure 280 in the above some examples may be referred to for the specific structure of the third stack structure 270 and the fourth stack structure 280.

As shown in Figs. 8, 9 and 17, some examples of the present disclosure further provide a memory device 10 including a first stack structure 210 and a second stack structure 220 stacked in the first direction, a first select gate 261, a second select gate 262 and a bit line BL. The first stack structure 210 includes a plurality of first gate layers 211 and a plurality of first dielectric layers 212 stacked alternatively in the first direction X. The second stack structure 220 includes a plurality of second gate layers 221 and a plurality of second dielectric layers 222 stacked alternatively in the first direction X.

The first select gate 261 is located on a side of the first stack structure 210 close to the second stack structure 220, and the second select gate 262 is located on a side of the second stack structure 220 close to the first stack structure 210. Illustratively, the first gate layer 211 in the plurality of first gate layers 211 that is closest to the second stack structure 220 may be configured as the first select gate 261, and the second gate layer 221 in the plurality of second gate layers 221 that is closest to the first stack structure 210 may be configured as the second select gate 262.

The bit line BL may be located between the first select gate 261 and the second select gate 262, the bit line BL may be connected with the first select gate 261, and the bit line may be connected with the second select gate 262. The bit line BL has an extending direction intersecting the first direction X. Illustratively, the bit line BL may extend in the Y-Z plane. For example, the extending direction of the bit line BL may be parallel to the third direction Z. The number of bit lines BL is plurality, and the plurality of bit lines BL are arranged at intervals in the second direction Y.

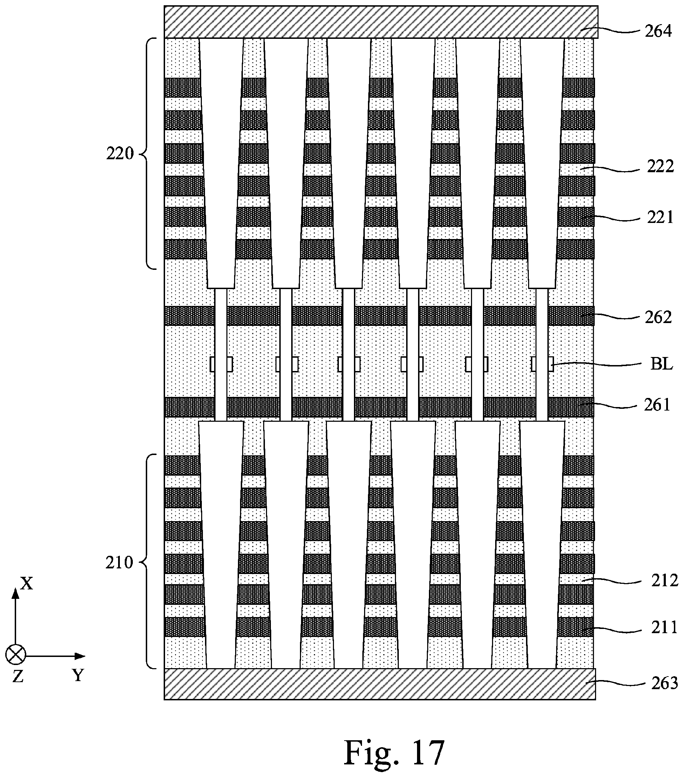

As shown in Fig. 17, the bit line BL is connected with the channel structure in the first stack structure 210 and also connected with the channel structure in the second stack structure 220. With the above-described arrangement, the bit line BL is located between the first stack structure 210 and the second stack structure 220. The bit line BL may drive upwardly the channel structure in the first stack structure 210 and at the same time drive downwardly the channel structure in the second stack structure 220. In some other examples, when the bit line BL is located at the topmost end of the plurality of stack structures (in the present example, the end of the second stack structure 220 away from the first stack structure 210), since there is a resistance in the channel structures, the current intensity in the channel structure away from the bit line BL is weak. As compared to the approach in which the bit line BL is located at the topmost end of the plurality of stack structures, in the present example, the bit line BL is located between the first stack structure 210 and the second stack structure 220, which facilitates improving the current intensity in the channel structure, thereby mitigating the problem of weak current intensity in the channel structure away from the bit line BL.

In some examples, as shown in Fig. 9, the memory device 10 includes a first connection structure 230. The first connection structure 230 is located on a side of the first stack structure 210 and the second stack structure 220 in the second direction Y. The first connection structure 230 is connected with at least one of the first gate layers 211 and the first connection structure 230 is connected with at least one of the second gate layers 221.

In the present example, description of the first connection structure 230 in the above some examples may be referred to for the first connection structure 230, which will not be described again herein.

With the above-described arrangement, one first gate layer 211 and one second gate layer 221 may share one first connection structure 230 and share one SD device. Then, when the memory device 10 has two stack structures, namely the first stack structure 210 and the second stack structure 220, as compared to the case in which one first gate layer 211 is connected with one SD device through one gate line contact G-CNT (referring to Figs. 4 and 8) and one second stack structure 221 is connected with one SD device through one gate line contact G-CNT, in the present example, the number of the first connection structures 230 is smaller than the number of the gate line contacts G-CNT, and the number of the SD devices in the present example is also small. Therefore, the area occupied by the first connection structures 230 is smaller than the area occupied by the gate line contacts G-CNT, and at the same time the area occupied by the SD devices is reduced, which facilitates improving the memory density of the memory device 10.

When the memory device 10 includes more stack structures, for example, the memory device 10 may include 4, 6 or 8 stack structures, at this time, the first connection structure 230 may be connected with one gate layer in each stack structure of the plurality of stack structures. With the above-described arrangement, even more stack structures are added, the number of first connection structures 230 will not increase, that is, the area occupied by the first connection structures 230 is not increased, which facilitates improving the memory density of the memory device 10 and facilitates the development of the memory device 10 towards large capacity and small volume.

In addition, as described above, in the art, in order to improve the capacity of the memory device 10, the number of the stack structures is increased, and the number of the SD devices is increased accordingly, and in order to control the size of the memory device 10, the problem of shrinking the size of the SD device needs to be addressed. With the present example in which a first connection structure 230 is connected with one gate layer in each stack structure of the plurality of stack structures, the number of the SD devices will not be increased, and therefore it is possible to mitigate the requirement of shrinking the size of SD device.

In some examples, as shown in Figs. 16 and 17, the memory device 10 further includes a third select gate 263, a fourth select gate 264 and a second connection structure 240. The third select gate 263 is located on a side of the first stack structure 210 away from the second stack structure 220, the fourth select gate 264 is located on a side of the second stack structure 220 away from the first stack structure 210. Illustratively, among the plurality of first gate layers 211, the first gate layer 211 that is farthest from the second stack structure 220 may be configured as the third select gate 263. Among the plurality of second gate layers 221, the second gate layer 221 that is farthest from the first stack structure 210 may be configured as the fourth select gate 264.

The second connection structure 240 is located on a side of the first stack structure 210 and the second stack structure 220 in the second direction Y. The second connection structure 240 and the first connection structure 230 may be located on the same side of the first stack structure 230 and the second stack structure 220. One of the first select gate 261, the second select gate 262, the third select gate 263 and the fourth select gate 264 is connected with the second connection structure 240.

With the above-described arrangement, the memory device 10 may choose to turn on the channel structure in the first stack structure 210 or the channel structure in the second stack structure 220 through the second connection structure 240 and then further choose to read or write the memory nodes in the first stack structure 210 or the second stack structure 220 through the first connection structure 230 and the bit line BL.

Illustratively, the number of the second connection structures 240 may be plurality, for example, one second connection structure 240 connected with the first select gate 261, one second connection structure 240 connected with the second select gate 262, one second connection structure 240 connected with the third select gate 263, and one second connection structure 240 connected with the fourth select gate 264. Thus, a plurality of second connection structures 240 are disposed. When a certain second connection structure 240 is in poor connection, the first stack structure 210 and the second stack structure 220 may be selected through other second connection structures 240, thus facilitating improving the memory stability of the memory device 10.

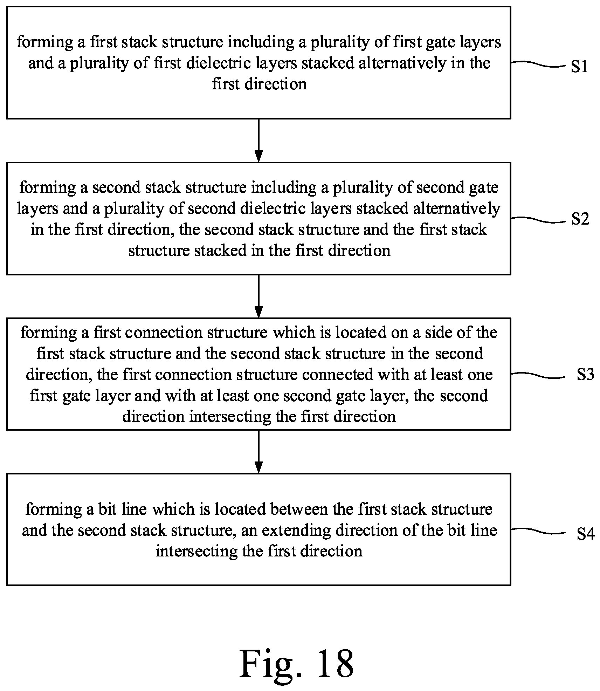

Some examples of the present disclosure provide a manufacturing method of the memory device that will be described below with reference to Figs. 18-43.

Fig. 18 is a flowchart of a manufacturing method of a memory device according to some examples. As shown in Fig. 18, the manufacturing method of the memory device as provided in some examples of the present disclosure includes S1~S4.

S1, forming a first stack structure including a plurality of first gate layers and a plurality of first dielectric layers stacked alternatively in the first direction.

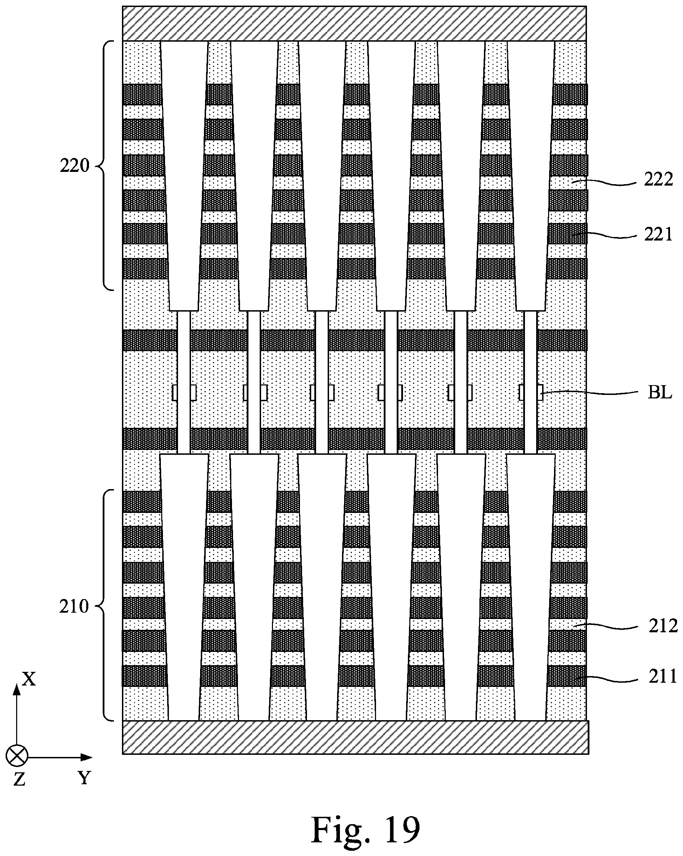

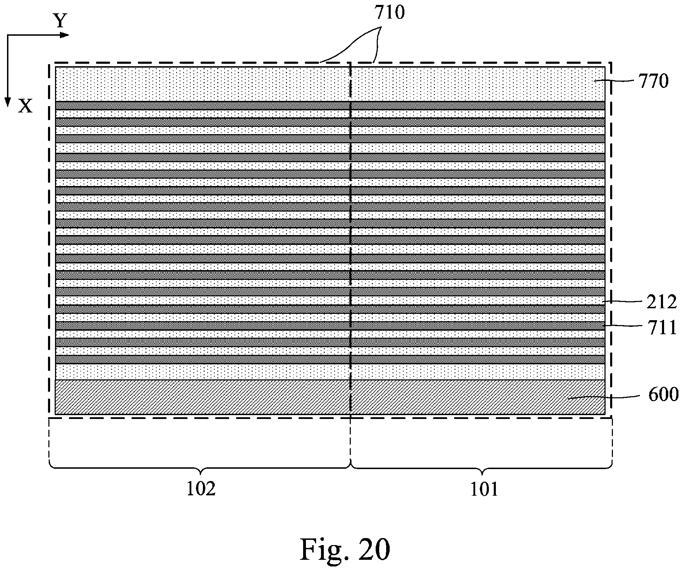

In this operation, referring to Figs. 19 and 20, a semiconductor layer 600 is provided and the first stack structure 210 is formed on the semiconductor layer 600. As an example, the first dielectric layers 212 and the first gate layers 211 may be formed alternatively on the semiconductor layer 600 by deposition process. The deposition process includes, but not limited to one or more film deposition processes of physical vapor deposition (PVD), chemical vapor deposition (CVD), atomic layer deposition (ALD).

The semiconductor layer 600 may include silicon (e.g., single crystalline silicon), silicon germanium (SiGe), gallium arsenide (GaAs), germanium (Ge), germanium-on-insulator (GOI) and/or any other suitable semiconductor material. In some examples, the semiconductor layer 600 includes silicon, such as single crystalline silicon, poly-crystalline silicon.

The first stack structure 210 includes a plurality of first gate layers 211 and a plurality of first dielectric layers 212 stacked alternatively in the first direction X. For example, the first gate layers 211 and the first dielectric layers 212 stacked alternatively in the first direction X are stacked to form a plurality of first gate layers 211 and a plurality of first dielectric layers 212 spaced apart from each other. It is also understood as that one first gate layer 211 and one first dielectric layer 212 together constitute one first gate structure pair and the first stack structure 210 includes a plurality of first gate structure pairs stacked in the first direction X.

Illustratively, the number of the first gate layers 211 and the first dielectric layers 212 may be 4, 16, 32, 64, 128, 256, etc. The thickness (namely the size in the first direction X) of the first gate layer 211 may be approximately equal to or different from the thickness of the first dielectric layer 212. For example, the thickness of the first dielectric layer 212 is greater than the thickness of the first gate layer 211.

Illustratively, the first gate layers 211 may include conductive materials including, but not limited to a combination of one or more of tungsten (W), cobalt (Co), copper (Cu), aluminum (Al), polysilicon, doped silicon, silicide, or may also be other suitable conductive materials. In some examples, the first gate layer 211 includes a metal layer such as a tungsten layer. In some examples, the first gate layer 211 includes a doped polysilicon layer. It is possible to dope polysilicon to a desired doping concentration with suitable dopant such that the polysilicon can serve as the conductive material for the first gate layers 211.

Illustratively, the first dielectric layers 212 may include an insulating material that may include a combination of one or more of silicon oxide, silicon nitride, silicon oxynitride and high dielectric constant insulating material, or other suitable insulating materials. The dielectric constant of the silicon oxynitride is higher than that of the silicon oxide. For example, in an environment under about 20°C, the dielectric constant of silicon oxynitride is between 4~7, for example, 3.8, 4, 4.8, 5.3, 5.9, 6, 6.36, 6.88, 7, 7.2 etc. In some examples, the first dielectric layer 212 includes a silicon oxide layer. In some examples, the first dielectric layer 212 includes a silicon oxynitride layer.

Illustratively, the thickness (namely the size in first direction X) of the first gate layer 211 may be between 10nm~50nm, for example, 10nm, 15nm, 18.3nm, 20nm, 25nm, 27.7nm, 30nm, 35nm, 40nm, 45nm, 50nm etc. Similarly, the thickness (namely the size in third direction Z) of the first dielectric layer 212 may be between 10nm~50nm, for example, 10nm, 15nm, 18.3nm, 20nm, 25nm, 27.7nm, 30nm, 35nm, 40nm, 45nm, 50nm etc. The first gate layer 211 may be the gate line G surrounding the memory cell string (referring to Fig. 6) and may extend laterally (i.e., in the second direction Y) as a word line WL (referring to Fig. 4).

S2, forming a second stack structure including a plurality of second gate layers and a plurality of second dielectric layers stacked alternatively in the first direction, the second stack structure and the first stack structure stacked in the first direction.

In this operation, referring to Figs. 19, 20 and 21, before forming the second stack structure 220, an isolating dielectric layer 770 may be formed with a deposition process on the first stack structure 210. Illustratively, the material for the isolating dielectric layer 770 may be the same as the first dielectric layer 212. Forming the first dielectric layer 212 on top of the first stack structure 210 and forming the isolating dielectric layer 770 may be done in the same process step.

After forming the isolating dielectric layer 770, the second dielectric layers 222 and the second gate layers 221 may be formed alternatively by a deposition process on the isolating dielectric layer 770. The example of the constituting materials, thicknesses and numbers of the first gate layers 211 and the first dielectric layers 212 above may be referred to for the constituting materials, thicknesses and numbers of the second gate layers 221 and the second dielectric layers 222. The constituting materials, thicknesses and numbers of the second gate layers 221 and the first gate layers 211 may be the same or different, and the constituting materials, thicknesses and numbers of the second dielectric layers 222 and the first dielectric layers 212 may be the same or different.

S3, forming a first connection structure which is located on a side of the first stack structure and the second stack structure in the second direction, the first connection structure connected with at least one first gate layer and at least one second gate layer, the second direction intersecting the first direction.

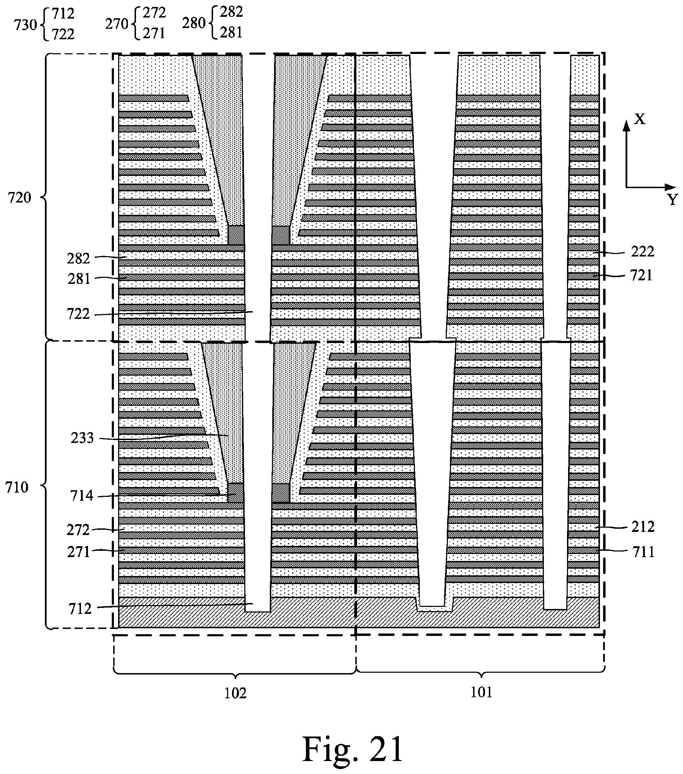

In this operation, referring to Fig. 21, before forming the first connection structure 230, a third stack structure 270 and a fourth stack structure 280 stacked alternatively may be formed on a side of the first stack structure 210 and the second stack structure 220 in the second direction Y. The first connection structure 230 is formed by etching process and deposition process. And the first connection structure 230 is connected with at least one first gate layer 211 and the first connection structure 230 is connected with at least one second gate layer 221.

Illustratively, the constituting material for the first connection structure 230 may include conductive materials including, but not limited to a combination of one or more of tungsten (W), cobalt (Co), copper (Cu), aluminum (Al), polysilicon, doped silicon, silicide, or may also be other suitable conductive materials.

After forming the first connection structure 230, a SD device electrically connected with the first connection structure 230 may be formed.

In the memory device 10 manufactured by the above-described operations, one SD device may be electrically connected with at least one first gate layer 211 and at least one second gate layer 221 through the first connection structure 230. One first gate layer 211 and one second gate layer 221 may share one first connection structure 230 and share one SD device. Then, when the memory device 10 has two stack structures, namely the first stack structure 210 and the second stack structure 220, as compared to the case in which one first gate layer 211 is connected with one SD device through one gate line contact G-CNT and one second stack structure 221 is connected with one SD device through one gate line contact G-CNT, in the present example, the number of the first connection structures 230 is smaller than the number of the gate line contacts G-CNT, and the number of the SD devices in the present example is also small. Therefore, the area occupied by the first connection structures 230 is smaller than the area occupied by the gate line contacts G-CNT, and at the same time the area occupied by the SD devices is reduced, which facilitates improving the memory density of the memory device 10.

After forming the second stack structure 220 and before forming the first connection structure 230, it is also possible to form a plurality of stack structures in the first direction X, for example, 2, 4 or 6 stack structures. After forming the plurality of stack structures, while forming the first connection structure 230, the first connection structure 230 may be connected with one gate layer in each stack structure of the plurality of stack structures.

With the memory device 10 formed by the above-described manufacturing method, the number of the first connection structures 230 will not increase even if more stack structures are formed. Therefore, with the memory device 10 formed by the above-described manufacturing method, the area occupied by its first connection structures 230 will not increase with the increase of the number of stack structures, which facilitates improving the memory density of the memory device 10 and facilitates the development of the memory device 10 towards large capacity and small volume.

In addition, in the art, in order to improve the capacity of a memory device 10, the number of stack structures is increased, and the number of SD devices is increased accordingly, and in order to control the size of the memory device 10, the problem of shrinking the size of SD device needs to be addressed. The first connection structure 230 obtained with the manufacturing method of the present example is connected with one gate layer in each stack structure of the plurality of stack structures, the number of the SD devices will not be increased, and therefore it is possible to mitigate the requirement of shrinking the size of the SD device.

S4, forming a bit line which is located between the first stack structure and the second stack structure, the bit line having an extending direction intersecting the first direction.

In this operation, as shown in Fig. 19, the extending direction of the bit line BL intersects the first direction X. For example, the bit line BL may extend in the third direction Z.

With the memory device 10 manufactured in this operation, the bit line BL is located between the first stack structure 210 and the second stack structure and the bit line BL is connected with the channel structure in the first stack structure 210 and also connected with the channel structure in the second stack structure 220. Therefore, the bit line BL may drive upwardly the channel structure in the first stack structure 210 and at the same time drive downwardly the channel structure in the second stack structure 220. As compared to the scheme in which the bit line BL is formed on the second stack structure, in the present example, forming the bit line BL between the first stack structure 210 and the second stack structure 220 facilitates improving the current intensity in the channel structure in the first stack structure 210 and the current intensity in the channel structure in the second stack structure 220, thereby mitigating the problem of weak current intensity in the channel structure away from the bit line BL.

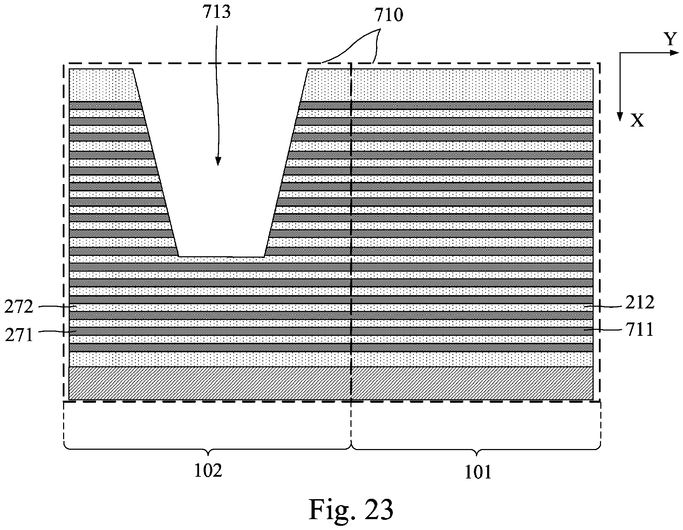

In some examples, as shown in Fig. 23, forming the first stack structure 210 includes: forming a first deck structure 710, a first region 101 of the first deck structure 710 includes a plurality of first sacrificial layers 711 and a plurality of first dielectric layers 212 stacked alternatively in the first direction. The first region 101 of the first deck structure 710 is adjacent to the second region 102 of the first deck structure 710 and the second region 102 of the first deck structure 710 is located on a side of the first region 101 of the first deck structure 710 in the second direction Y.

In this operation, as shown in Fig. 23, for example, the first dielectric layers 212 and the first sacrificial layers 711 may be formed alternatively with a deposition process. Illustratively, the material for the first dielectric layers 212 may be silicon oxide, and the material for the first sacrificial layers 711 may be silicon nitride.

As shown in Fig. 21, forming the second stack structure 220 includes: forming a second deck structure 720 located on a side of the bit line BL away from the first deck structure 710, a first region 101 of the second deck structure 720 includes a plurality of second sacrificial layers 721 and a plurality of second dielectric layers 222 stacked alternatively in the first direction. The first region 101 of the second deck structure 720 is adjacent to the second region 102 of the second deck structure 720 and the second region 102 of the second deck structure 720 is located on a side of the first region 101 of the second deck structure 720 in the second direction Y.

In this operation, as shown in Fig. 21, for example, the second dielectric layers 222 and the second sacrificial layers 721 are formed alternatively on the first deck structure 710 with a deposition process. Illustratively, the material for the second dielectric layers 222 may be silicon oxide, and the material for the second sacrificial layers 721 may be silicon nitride.

As shown in Fig. 21, after forming the first deck structure 710, and before forming the second deck structure 720, the method includes: removing a portion of the first deck structure 710 to form a first connection hole 712 located in the second region 102 of the first deck structure 710.

In this operation, the first connection hole 712 may extend through the first deck structure 710 into the semiconductor layer 600. The first connection hole 712 may be formed with any suitable process. For example, it is possible to form a patterned photoresist layer on the first deck structure 710. The patterned photoresist layer can expose a portion of the first deck structure 710 that is for forming the first connection hole 712. It is possible to execute suitable etch process to remove the portion of the first deck structure 710 that is for forming the first connection hole 712. For example, the etching process may include dry etch process.

After forming the first connection hole 712, it is possible to remove the patterned photoresist layer on the first deck structure 710 by for example planarizing the surface of the first deck structure 710 with chemical mechanical polishing (CMP) to remove the patterned photoresist layer on the first deck structure 710.

In some examples, the operation of removing a portion of first deck structure 710 to form the first connection hole 713 further includes: forming a first gate line slit 743 located in the first region 101 of the first deck structure 710.

In this operation, referring again to Fig. 21, it is also possible to form a first channel hole 751. The first gate line slit is located between the first channel hole 751 and the first connection hole 712. The first channel hole 751 and the first gate line slit are both located in the first region 101 of the first deck structure 710. The first connection hole 712, the first gate line slit and the first channel hole 751 may be formed in one process step. For example, the process step is dry etch process. Forming the first connection hole 712, the first gate line slit and the first channel hole 751 in one process step facilitates simplifying the manufacturing process steps and saving manufacturing costs for the memory device 10.

Referring again to Fig. 21, after forming the second deck structure 720, and before forming the first connection structure 230, the method includes: removing a portion of second deck structure 720 to form a second connection hole 722 located in the second region 102 of the second deck structure 720. The second connection hole 722 and the first connection hole 712 together constitute the connection hole 730.

In this operation, the second connection hole 722 may extend through the second deck structure 720 to the first connection hole 712. The second connection hole 722 may be formed with any suitable process. For example, it is possible to form a patterned photoresist layer on the second deck structure 720. The patterned photoresist layer can expose a portion of the second deck structure 720 that is for forming the second connection hole 722. It is possible to perform a suitable etch process to remove the portion of the second deck structure 720 that is for forming the second connection hole 722. For example, the etching process may include dry etch process.

After forming the second connection hole 722, it is possible to remove the patterned photoresist layer on the second deck structure 720 by for example planarizing the surface of the second deck structure 720 with chemical mechanical polishing (CMP) to remove the patterned photoresist layer on the second deck structure 720.

In some examples, the operation of removing a portion of second deck structure 720 to form the second connection hole 722 further includes: forming a second gate line slit 744 located in the first region 101 of the second deck structure 720. The second gate line slit 744 and the first gate line slit 743 together constitute the gate line slit 760.

In this operation, referring again to Fig. 21, it is also possible to form a second channel hole 752. The second gate line slit is located between the second channel hole 752 and the second connection hole 722. The second channel hole 752 and the second gate line slit are both located in the first region 101 of the second deck structure 720. The second connection hole 722, the second gate line slit and the second channel hole 752 may be formed in one process step. For example, the process step is dry etch process. Forming the second connection hole 722, the second gate line slit and the second channel hole 752 in one process step facilitates simplifying the manufacturing process steps and saving manufacturing costs for the memory device 10.

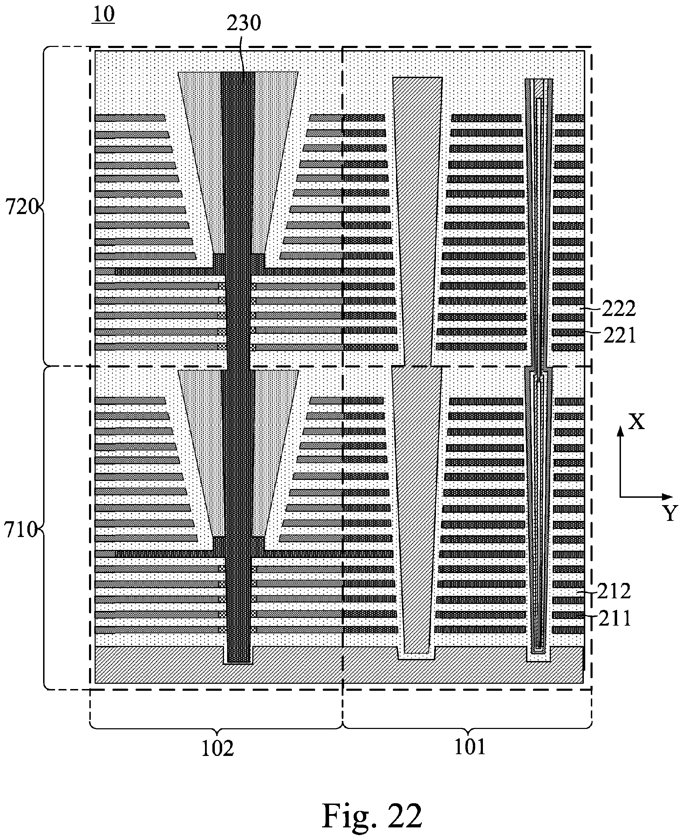

After forming the second deck structure 720 and before forming the first connection structure 230, as shown in Figs. 21 and 22, the method further includes: replacing the first sacrificial layer 711 with a first gate layer 211 and replacing the second sacrificial layer 721 with a second gate layer 221.

As shown in Figs. 21 and 22, forming the first connection structure 230 includes depositing a conductive material in the connection hole 730 to form the first connection structure 230. Illustratively, the conductive material includes, but not limited to a combination of one or more of tungsten (W), cobalt (Co), copper (Cu), aluminum (Al), polysilicon, doped silicon, silicide, or may also be other suitable conductive materials.

The deposition process includes, but not limited to one or more film deposition processes of physical vapor deposition (PVD), chemical vapor deposition (CVD), atomic layer deposition (ALD).

With the manufacturing method in the present example, it is possible to form the first connection hole 712, the first gate line slit and the first channel hole 751 in one process step. Forming the second connection hole 722, the second gate line slit and the second channel hole 752 in one process step facilitates simplifying the manufacturing process steps and saving manufacturing costs for the memory device 10.

In some examples, referring to Figs. 22 and 23, after forming the first deck structure 710 and before removing a portion of first deck structure 710, as shown in Fig. 23, the method further includes: forming a first groove 713 located in the second region 102 of the first deck structure 710 and extending through a portion of first deck structure 710 in the first direction X, wherein the second region 102 of the first deck structure 710 includes a plurality of third dielectric layers 271 and a plurality of fourth dielectric layers 272 stacked alternatively in the first direction X, and at least one third dielectric layer 271 is connected with the first sacrificial layer 711.

In this operation, referring again to Fig. 23, the third dielectric layer 271 and the first sacrificial layer 711 may be the film layer formed in one patterning process. The fourth dielectric layer 272 and the first dielectric layer 212 may be the film layer formed in one patterning process. The patterning process refers to a process capable of forming at least one pattern with a certain shape. For example, a film is formed on a substrate by any one of a variety of film forming processes such as deposition, coating and sputtering, and then the film is patterned to form a film layer including at least one pattern, which is referred to as a pattern layer. The operation of patterning includes coating photoresist, exposure, development, etching and stripping photoresist, etc.

Referring to Figs. 23, 24, 25 and 26, after forming the first groove 713, the method further includes forming a first connection sacrificial layer 714.

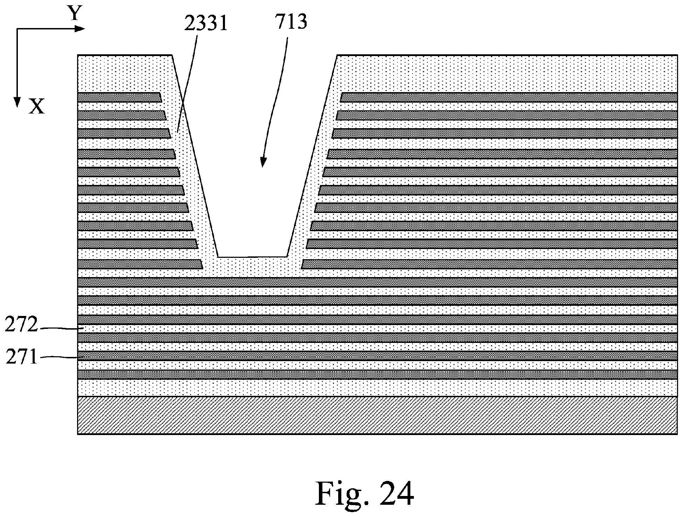

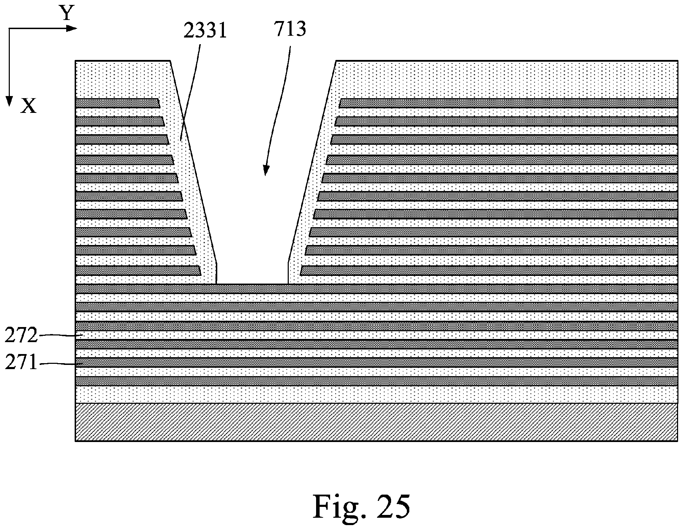

In this operation, referring to Figs. 24 and 25, forming the first connection sacrificial layer 714 includes: forming a first sub isolation layer 2331 covering walls of the first groove 713. Illustratively, it is possible to deposit an isolation material in the first groove 713. The isolation material is for example a combination of one or more of silicon oxide, silicon nitride and high dielectric constant insulating material, and may also be other isolation material. After depositing the isolation material in the first groove 713, it is possible to remove the isolation material at the bottom of the first groove 713 and the fourth dielectric layer 272 at the bottom of the first groove 713 to form the first sub isolation layer 2331 covering the walls of the first groove 713 and exposing the third dielectric layer 271.

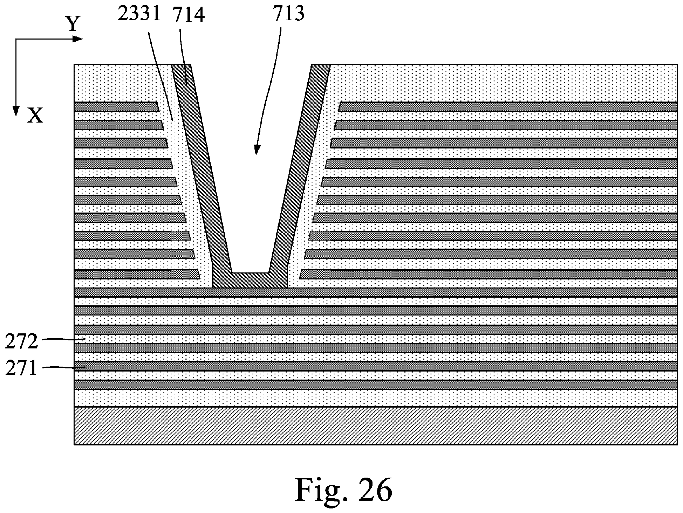

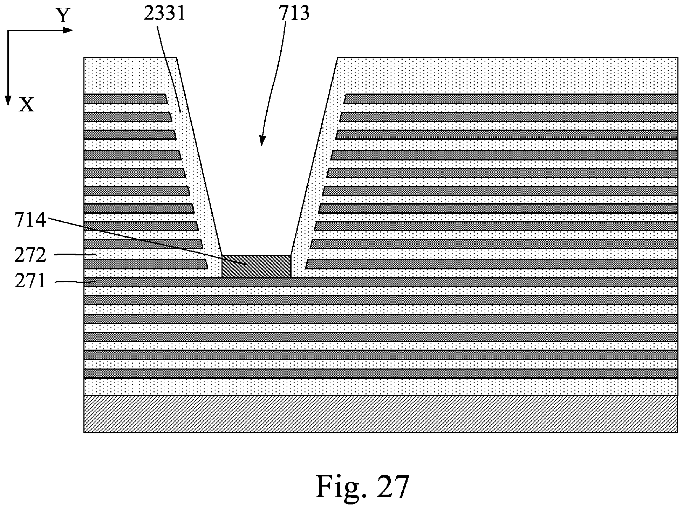

Referring to Figs. 26 and 27, after forming the first sub isolation layer 2331, a dielectric material is deposited in the first groove 713 covering the bottom of the first groove 713. The dielectric material covering the bottom of the first groove 713 is subjected to ion implanting to remove the dielectric material covering walls of the first groove 713 to form the first connection sacrificial layer 714. The first connection sacrificial layer 714 covers the bottom of the first groove 713 and contacts the third dielectric layer 271.

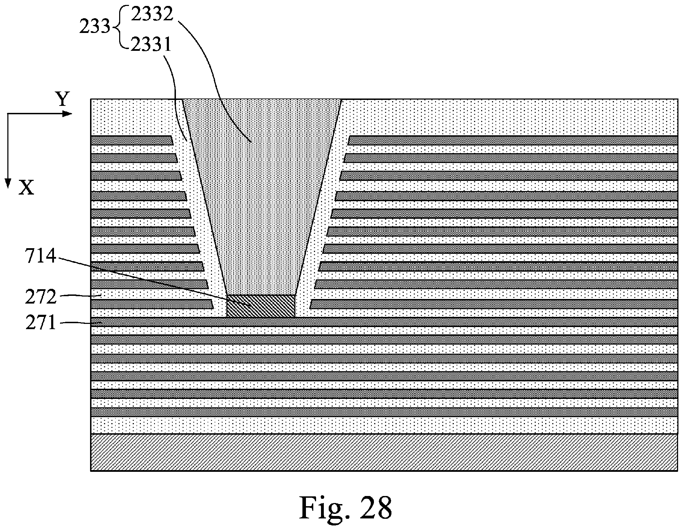

Referring to Fig. 28, after forming the first connection sacrificial layer 714, the method further includes: forming a first isolation layer 233 which is located in the first groove 713. In this operation, as shown in Fig. 28, forming the first isolation layer 233 includes: forming a second sub isolation layer 2332 in the first groove 713, the second sub isolation layer 2332 may be formed by depositing an isolation material in the first groove 713 with one or more film deposition process including, but not limited to PVD, CVD, ALD. The second sub isolation layer 2332 and the first sub isolation layer 2331 together form the first isolation layer 233.

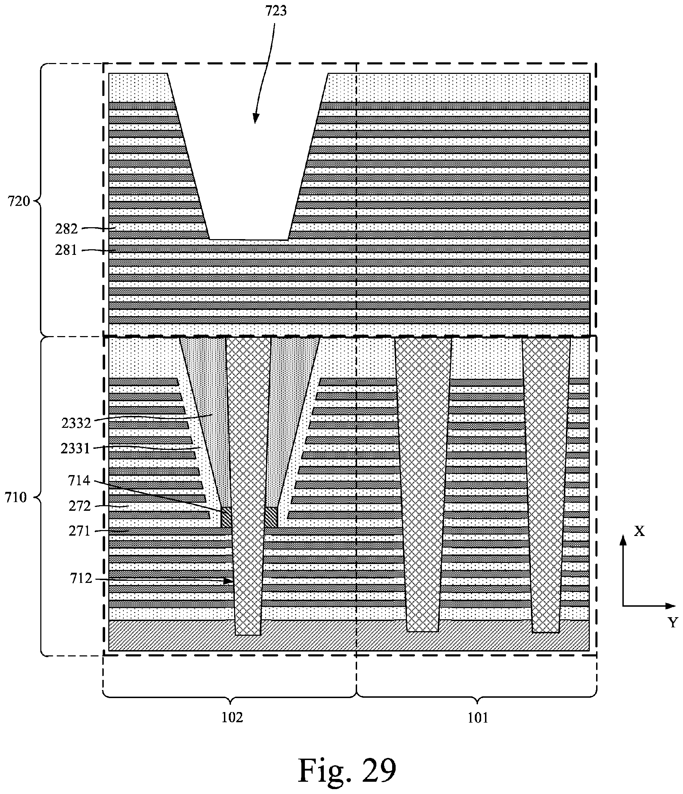

In some examples, as shown in Fig. 29, after forming the first isolation layer 233, a portion of the first deck structure 710 is removed to form the first connection hole 712, wherein removing a portion of the first deck structure 710 includes: removing the first isolation layer 233 and removing the first connection sacrificial layer 714 and the plurality of third dielectric layers 271 and the plurality of fourth dielectric layers 272 that are stacked to form the first connection hole 712.

In this operation, a portion of first isolation layer 233, a portion of first connection sacrificial layer 714 and a portion of the plurality of third dielectric layers 271 and the plurality of fourth dielectric layers 272 that are stacked may be removed with an etch process to form the first connection hole 712. The etching process includes dry etch process or wet etching process.

As shown in Fig. 29, after forming the first connection hole 712, it is possible to fill sacrificial material in the first connection hole 712 to facilitate subsequently forming the second stack structure 720 on the first stack structure 710.

In some examples, as shown in Fig. 29, after filling sacrificial material in the first connection hole 712, it is possible to form the second stack structure 720 on the first stack structure 710 with one or more film deposition processes including, but not limited to PVD, CVD and ALD.

In some examples, as shown in Fig. 29, after forming the second deck structure 720 and before removing a portion of second deck structure 720, the method further includes: forming a second groove 723 that is located in the second region 102 of the second deck structure 720 and extends through a portion of second deck structure 720 in the first direction X, wherein the second region 102 of the second deck structure 720 includes a plurality of fifth dielectric layers 281 and a plurality of sixth dielectric layers 282 stacked alternatively in the first direction X, and at least one fifth dielectric layer 281 is connected with the second sacrificial layer 721.

In this operation, referring again to Fig. 29, the fifth dielectric layer 281 and the second sacrificial layer 721 may be the film layer formed in one patterning process. The sixth dielectric layer 282 and the second dielectric layer 222 may be the film layer formed in one patterning process.

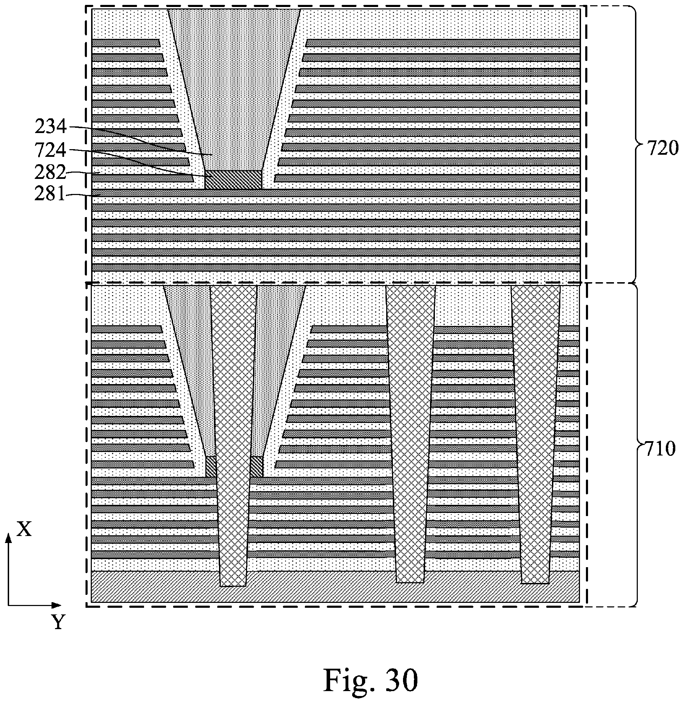

After forming the second groove 723, as shown in Fig. 30, the method further includes forming a second connection sacrificial layer 724. The second connection sacrificial layer 724 covers the bottom of the second groove 723 and contacts the fifth dielectric layer 281. The manufacturing method of the first connection sacrificial layer 714 in the above description may be referred to for the specific manufacturing method of the second connection sacrificial layer 724, which will not be described again herein.

After forming the second connection sacrificial layer 724, the method further includes: forming a second isolation layer 234 which is located in the second groove 723.

Removing a portion of second deck structure 720 to form the second connection hole 722 includes: removing the second isolation layer 234 and removing the second connection sacrificial layer 724 and the plurality of fifth dielectric layers 281 and the plurality of sixth dielectric layers 282 that are stacked to form the second connection hole 722.

In this operation, it is possible to remove a portion of second isolation layer 234, a portion of second connection sacrificial layer 724 and a portion of the plurality of fifth dielectric layers 281 and the plurality of sixth dielectric layers 282 that are stacked with an etch process to form the second connection hole 722. The etching process includes dry etch process or wet etching process.

After forming the second connection hole 722, it is possible to remove the sacrificial material in the first connection hole 712 such that the first connection hole 712 is in communication with the second connection hole 722, and the first connection hole 712 and second connection hole 722 together constitute the connection hole 730. Illustratively, when the sacrificial material includes carbon, the process for removing the sacrificial material in the first connection hole 712 may include ashing to remove all the sacrificial material in the first connection hole 712.

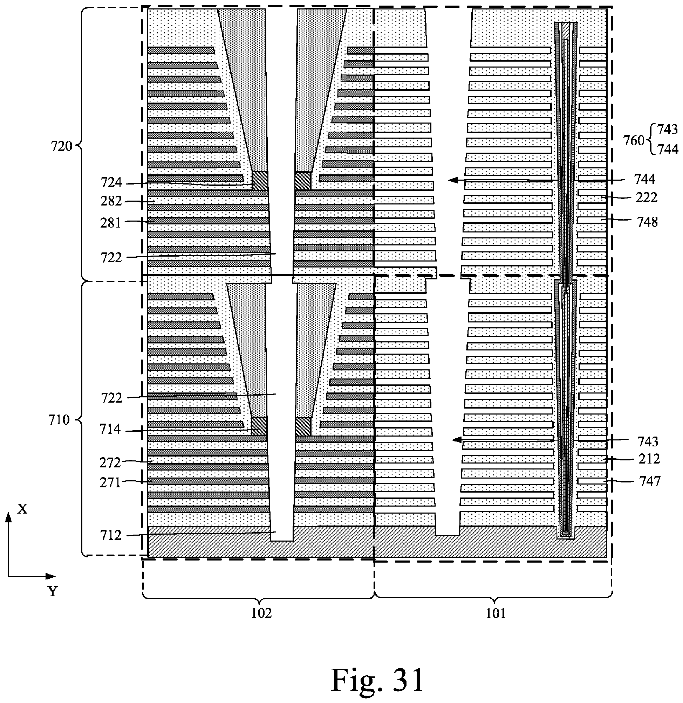

In some examples, as shown in Figs. 31, 32, 33 and 34, forming the first connection structure 230 in the connection hole includes: removing the first connection sacrificial layer 714 and the second connection sacrificial layer 724 to form a first recess space 715 and a second recess space 725, the first recess space 715 is in communication with the first connection hole 712, and the second recess space 725 is in communication with the second connection hole 722.

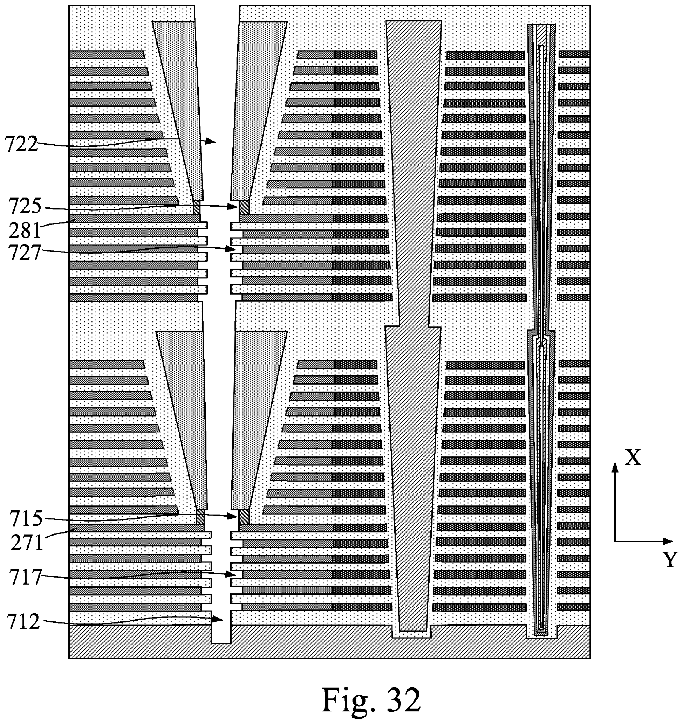

In this operation, referring to Figs. 31 and 32, it is possible to removing the first connection sacrificial layer 714 and the second connection sacrificial layer 724 by injecting etchant into the connection hole 730. The etchant has an etching rate for the third dielectric layer 271 and the fifth dielectric layer 281 greater than that for the fourth dielectric layer 272 and the sixth dielectric layer 282. The etching rates of the etchant for the first connection sacrificial layer 714 and the second connection sacrificial layer 724 may be approximately the same as that for the third dielectric layer 271 and the fifth dielectric layer 281, or the etching rates of the etchant for the first connection sacrificial layer 714 and the second connection sacrificial layer 724 may be smaller than that for the third dielectric layer 271 and the fifth dielectric layer 281.

Then in this operation, when removing the first connection sacrificial layer 714 and the second connection sacrificial layer 724, it is also possible to remove a portion of third dielectric layer 271 and a portion of fifth dielectric layer 281 to form a third recess space 717 and a fourth recess space 727, the third recess space 717 is in communication with the first connection hole 712, and the fourth recess space 727 is in communication with the second connection hole 722.

Since the first connection sacrificial layer 714 contacts one third dielectric layers 271 and the second connection sacrificial layer 724 contacts one fifth dielectric layers 281, in the first direction X, the thickness of the first connection sacrificial layer 714 and the one third dielectric layer 271 is greater than the thickness of one third dielectric layer 271; and in the first direction X, the thickness of the second connection sacrificial layer 724 and one fifth dielectric layer 281 is greater than the thickness of one fifth dielectric layer 281. Accordingly, after injecting etchant into the connection hole 730, in the second direction Y, the etched length of the third dielectric layer 271 that contacts the first connection sacrificial layer 714 is smaller than the etched length of other third dielectric layers 271; and in the second direction Y, the etched length of the fifth dielectric layer 281 that contacts the second connection sacrificial layer 724 is smaller than the etched length of other fifth dielectric layers 281.

At the location where the first connection sacrificial layer 714 and the second connection sacrificial layer 724 are removed, the first recess space 715 and the second recess space 725 are formed, in which the first recess space 715 is in communication with the first connection hole 712, and the second recess space 725 is in communication with the second connection hole 722. It is to be noted that the first connection sacrificial layer 714 and the second connection sacrificial layer 724 may be partially removed or completely removed.

It is to be noted that the first isolation layer 233 may protect the third dielectric layers 271 and the fourth dielectric layers 272 that surround the first isolation layer 233 from being etched, and the second isolation layer 234 may protect the fifth dielectric layers 281 and the sixth dielectric layers 282 that surround the second isolation layer 234 from being etched. Therefore, in this operation, it is possible to use an etch process and select an etchant that etches the third dielectric layers 271 and the fifth dielectric layers 281 at a faster rate and etches the fourth dielectric layers 272 and the sixth dielectric layers 282 at a slower rate (or not etch the fourth dielectric layers 272 and the sixth dielectric layers 282) to remove a portion of the third dielectric layers 271 exposed in the first connection hole 712 and a portion of the fifth dielectric layers 281 exposed in the second connection hole 722 to form the third recess space 717 and the fourth recess space 727.

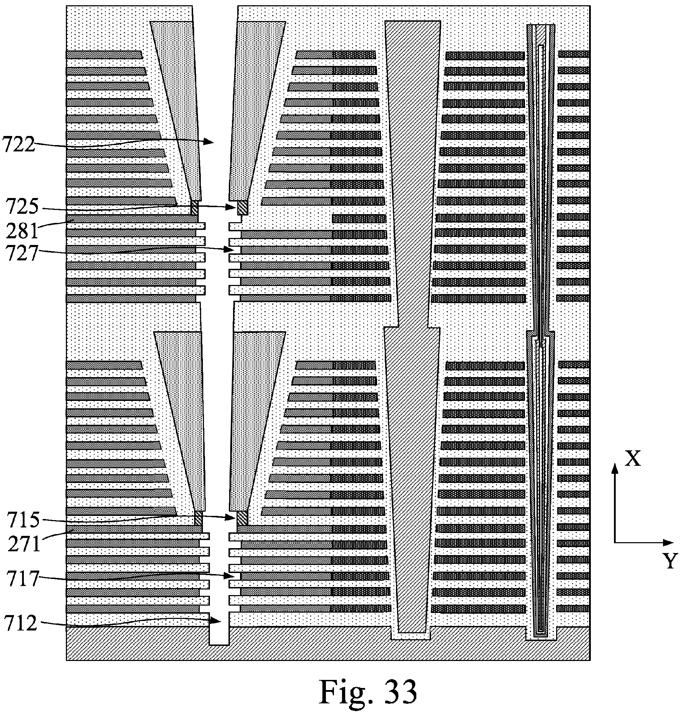

Referring to Figs. 32 and 33, it is possible to form the third isolation layer 235 in the third recess space 717 and form the fourth isolation layer 236 in the fourth recess space 727 with one or more film depression processes including, but not limited to PVD, CVD and ALD to protect the third dielectric layers 271 and the fifth dielectric layers 281 from being etched in subsequent manufacturing process.

It is to be noted that in this operation, it is known that in the first direction X, the thickness of the first connection sacrificial layer 714 and the one third dielectric layer 271 is greater than the thickness of one third dielectric layer 271; and in the first direction X, the thickness of the second connection sacrificial layer 724 and one fifth dielectric layer 281 is greater than the thickness of one fifth dielectric layer 281. Therefore, when forming the third isolation layers 235 in the third recess space 717 and forming the fourth isolation layers 236 in the fourth recess space 727, the third isolation layer 235 formed on the third dielectric layer 271 exposed in the first recess space 715 is thin, and the fourth isolation layer 236 formed on the fifth dielectric layer 281 exposed in the second recess space 725 is thin. It is possible to remove the third isolation layer 235 formed on the third dielectric layer 271 exposed in the first recess space 715 and the fourth isolation layer 236 formed on the fifth dielectric layer 281 exposed in the second recess space 725 with a small amount of etchant. And the third isolation layers 235 formed in the third recess space 717 and the fourth isolation layers 236 formed in the fourth recess space 727 are remained.

After forming the first recess space 715 and the second recess space 725, as shown in Figs. 32 and 33, the method further includes: removing the third dielectric layers 271 exposed in the first recess space 715 and the fifth dielectric layers 281 exposed in the second recess space 725 to form a first filling space 716 and a second filling space 726, the first filling space 716 is in communication with the first recess space 715, and the second filling space 726 is in communication with the second recess space 725.

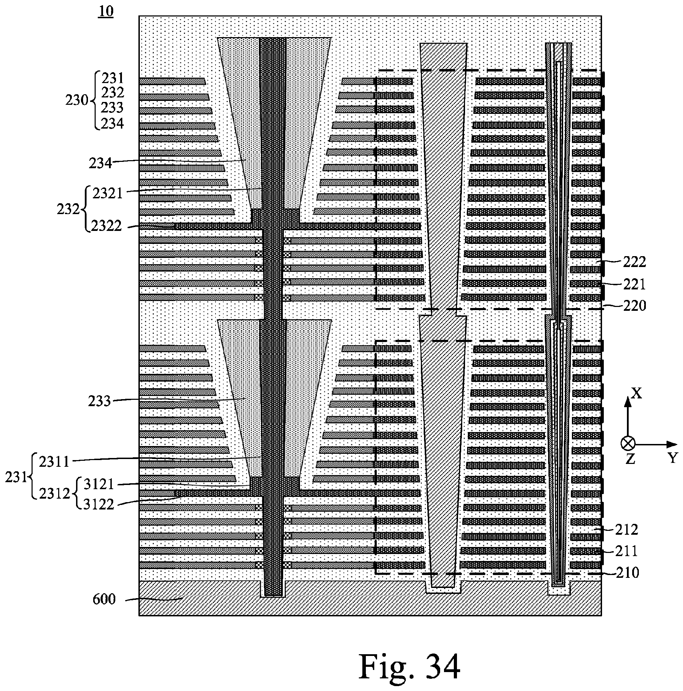

Referring to Figs. 33 and 34, after forming the first filling space 716 and the second filling space 726, the method further includes: filling a conductive material in the connection hole 730 to form the first connection structure 230.

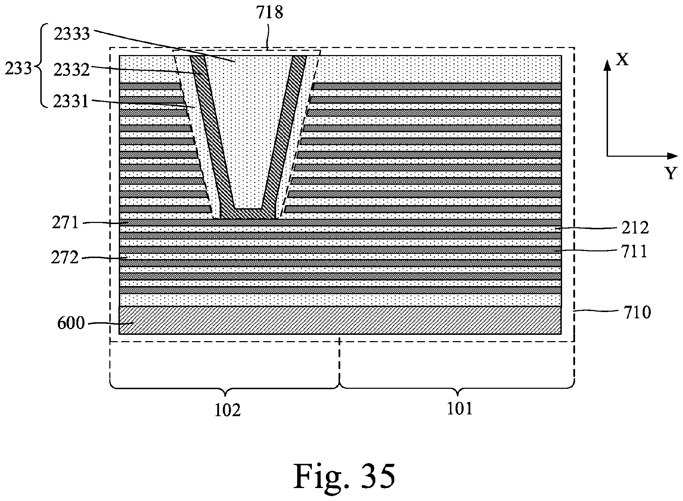

Some other examples of the present disclosure further provide a manufacturing method of a memory device. As shown in Fig. 35, after forming a first deck structure 710 and before removing a portion of the first deck structure 710, the method further includes: forming a third groove 718 which is located in the second region 102 of the first deck structure 710 and extends through a portion of the first deck structure 710 in the first direction X, wherein the second region 102 of the first deck structure 710 includes a plurality of third dielectric layers 271 and a fourth dielectric layers 272 stacked alternatively in the first direction, and at least one third dielectric layer 271 is connected with the first sacrificial layer 711.

In this operation, the third dielectric layer 271 and the first sacrificial layer 711 may be the film layer formed in one patterning process. The fourth dielectric layer 272 and the first dielectric layer 212 may be the film layer formed in one patterning process.

After forming the third groove 718, as shown in Fig. 35, the method further includes: forming a first sub isolation layer 2331 covering walls of the third groove 718.

In this operation, it is possible to remove the isolation material at the bottom of the third groove 718 after depositing the isolation material in the third groove 718 to form the first sub isolation layer 2331.

After forming the first sub isolation layer 2331, as shown in Fig. 35, the method further includes forming a second sub isolation layer 2332, the second sub isolation layer 2332 covers the bottom of the third groove 718 and contacts the third dielectric layer 271, and further covers a side of the first sub isolation layer 2331.

After forming the second sub isolation layer 2332, as shown in Fig. 35, the method further includes forming a third sub isolation layer 2333 in the third groove 718, the third sub isolation layer 2333 covers the second sub isolation layer 2332, and the first sub isolation layer 2331, the second sub isolation layer 2332 and the third sub isolation layer 2333 together constitute the first isolation layer 233.

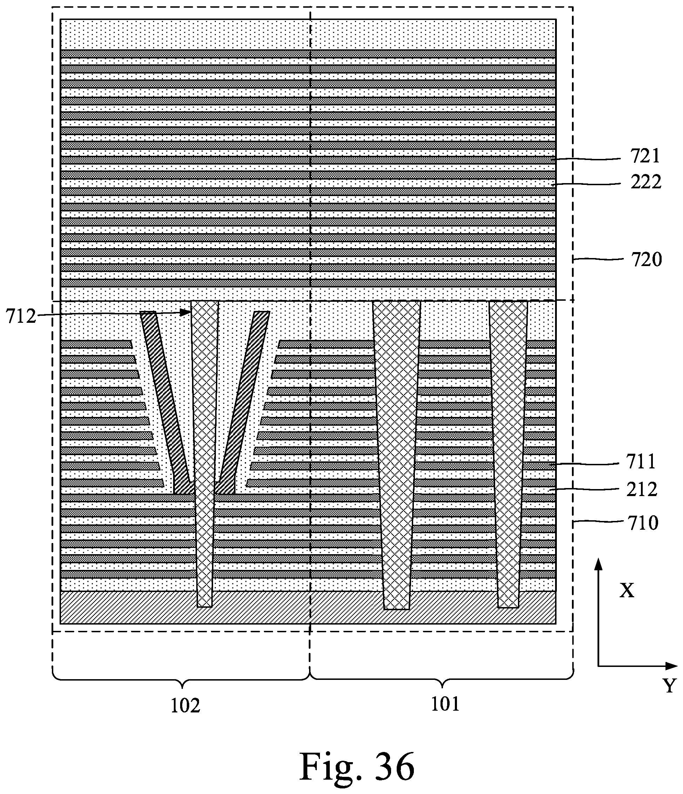

Referring to Fig. 36, after forming the second sub isolation layer 2332, the method further includes removing a portion of first deck structure 710 to form the first connection hole 712. The first connection hole 712 extends through the first deck structure 710 and is located in the first region 101 of the first deck structure 710.

In this operation, as shown in Figs. 35 and 36, the method further includes: removing the second sub isolation layer 2332, the third sub isolation layer 2333, the plurality of third dielectric layers 271 and the plurality of fourth dielectric layers 272 to form the first connection hole 712. After forming the first connection hole 712, it is possible to deposit a sacrificial material in the first connection hole 712 to facilitate subsequently forming the second stack structure 720 on the first stack structure 710.

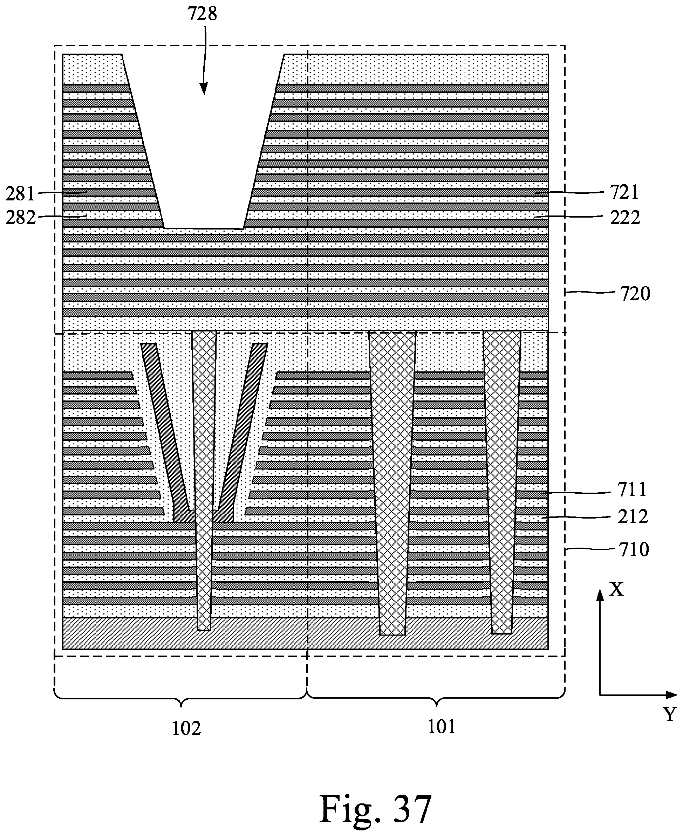

In some examples, as shown in Fig. 37, after forming the second deck structure 720 and before removing a portion of second deck structure 720, the method further includes: forming a fourth groove 728 which is located in the second region 102 of the second deck structure 720 and extends through a portion of second deck structure 720 in the first direction X. The second region 102 of the second deck structure 720 includes a plurality of fifth dielectric layers 281 and a plurality of sixth dielectric layers 282 stacked alternatively in the first direction X. At least one fifth dielectric layer 281 is connected with the second connection layer 721.

In this operation, referring again to Fig. 37, the fifth dielectric layer 281 and the second sacrificial layer 721 may be the film layer formed in one patterning process. The sixth dielectric layer 282 and the second dielectric layer 222 may be the film layer formed in one patterning process.

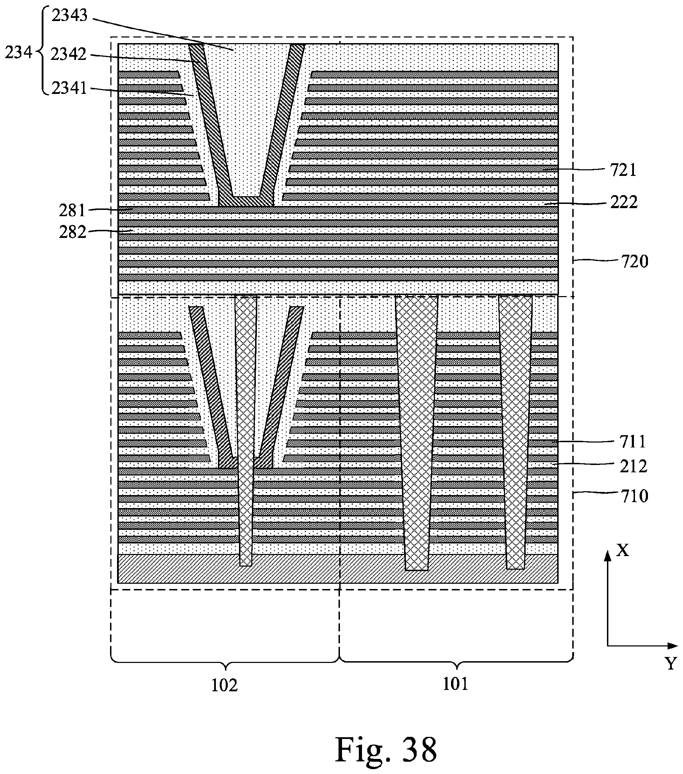

After forming the fourth groove 728, as shown in Figs. 37 and 38, the method further includes: forming a fourth sub isolation layer 2341 covering walls of the fourth groove 728. A fifth sub isolation layer 2342 is formed to cover the bottom of the fourth groove 728 and the fourth sub isolation layer 2341 and contact the fifth dielectric layer 281. A sixth sub isolation layer 2343 is formed in the fourth groove 728, the sixth sub isolation layer 2343 covers the fifth sub isolation layer 2342, and the fourth sub isolation layer 2341, the fifth sub isolation layer 2342 and the sixth sub isolation layer 2343 together constitute the second isolation layer 234.

In this operation, the manufacturing method for the first sub isolation layer 2331, the second sub isolation layer 2332 and the third sub isolation layer 2333 in the above some examples may be referred to for the method of forming the fourth sub isolation layer 2341, the fifth sub isolation layer 2342 and the sixth sub isolation layer 2343 in this operation, which will not be described again herein.

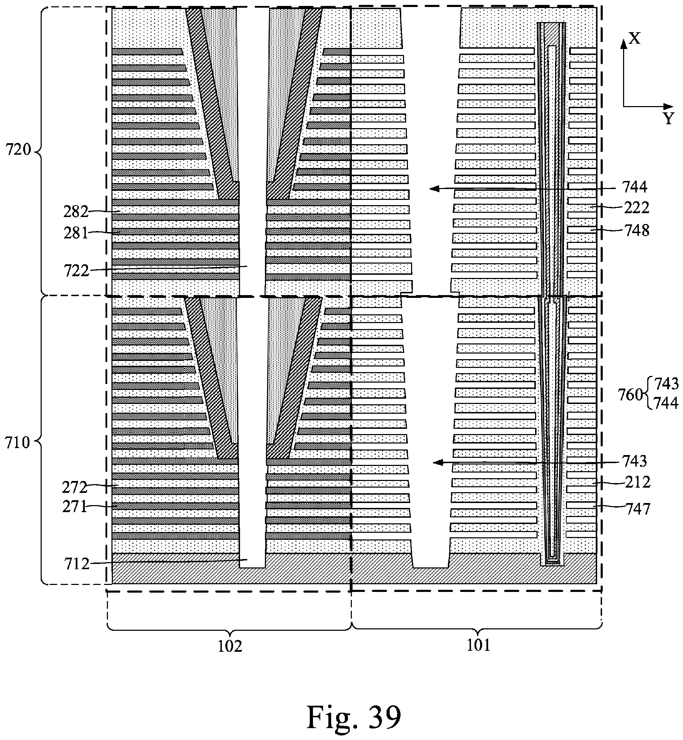

Referring to Figs. 38 and 39, after forming the second isolation layer 234, the method further includes removing a portion of the second deck structure 720 to form the second connection hole 722.

In this operation, removing a portion of the second deck structure 720 includes: removing the fifth isolation layer 2342, the sixth sub isolation layer 2343, the plurality of fifth dielectric layers 281 and the plurality of sixth dielectric layers 282 to form the second connection hole 722.

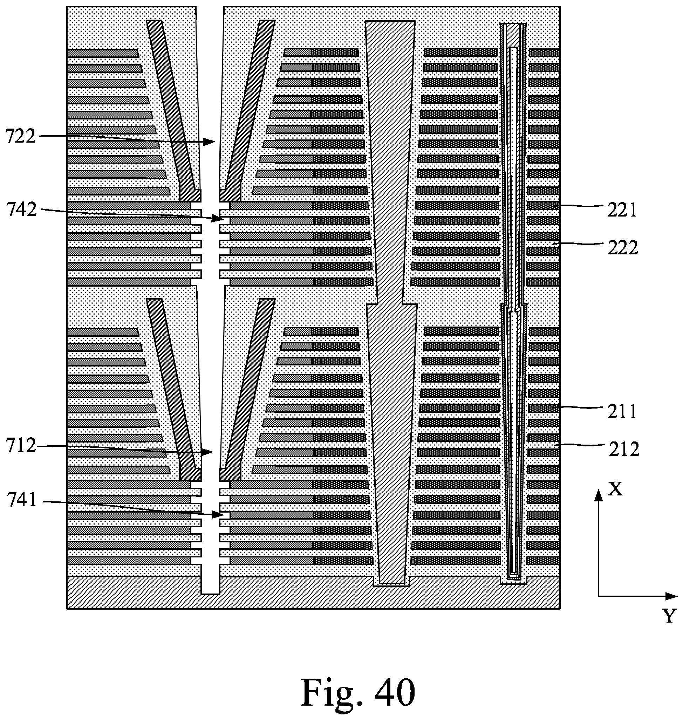

Referring to Figs. 39 and 40, in the operation of removing a portion of first deck structure 710 to form the first connection hole 712, it is possible to form a first gate line slit 743 located in the first region 101 of the first deck structure 710 synchronously. In the operation of removing a portion of second deck structure 720 to form the second connection hole 722, it is possible to form a second gate line slit 744 located in the first region 101 of the second deck structure 720 synchronously.

After forming the second gate line slit 744, it is possible to replace the first sacrificial layer 711 with a first gate layer 211 and replace the second sacrificial layer 721 with a second gate layer 221.

In this operation, as shown in Figs. 39 and 40, the method includes: injecting an etching solution into the gate line slit 760 to remove the first sacrificial layer 711 and the second sacrificial layer 721, thereby forming a fifth filling space 747 and a sixth filling space 748. A gate material is deposited in the fifth filling space 747 and the sixth filling space 748 to form the first gate layer 211 and the second gate layer 221.

In some examples, referring to Figs. 35, 40, 41 and 42, forming the first connection structure 230 in the connection hole 730 includes: removing the second sub isolation layer 2332 at the bottom of the third groove 718 and the fifth sub isolation layer 2342 at the bottom of the fourth groove 728 to form the fifth recess space 719 and the sixth recess space 729, the fifth recess space 719 is in communication with the first connection hole 712, and the sixth recess space 729 is in communication with the second connection hole 722.

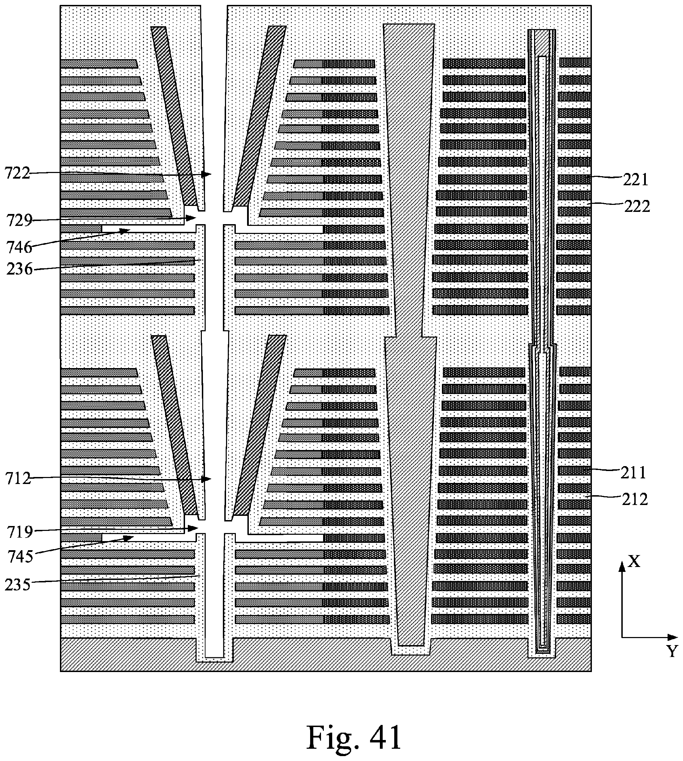

In this operation, referring to Figs. 40 and 41, before removing the second sub isolation layer 2332 at the bottom of the third groove 718 and the fifth sub isolation layer 2342 at the bottom of the fourth groove 728, the method further includes: removing a portion of the second dielectric layer 222 and a portion of the fourth dielectric layer 272 to form a seventh recess space 741 and an eighth recess space 742, the seventh recess space 741 is in communication with the first connection hole 712, and the eighth recess space 742 is in communication with the second connection hole 722. A third isolation layer 235 is formed in the seventh recess space 741 and a fourth isolation layer 236 is formed in the eighth recess space 742 to protect the second dielectric layer 222 and the fourth dielectric layer 272 from being damaged in subsequent etch process.

As shown in Fig. 41, after forming the fifth recess space 719 and the sixth recess space 729, the method further includes: removing the third dielectric layers 271 exposed in the fifth recess space 719 and the fifth dielectric layers 281 exposed in the sixth recess space 729 to form a third filling space 745 and a fourth filling space 746, the third filling space 745 is in communication with the fifth recess space 719, and the fourth filling space 746 is in communication with the sixth recess space 729.

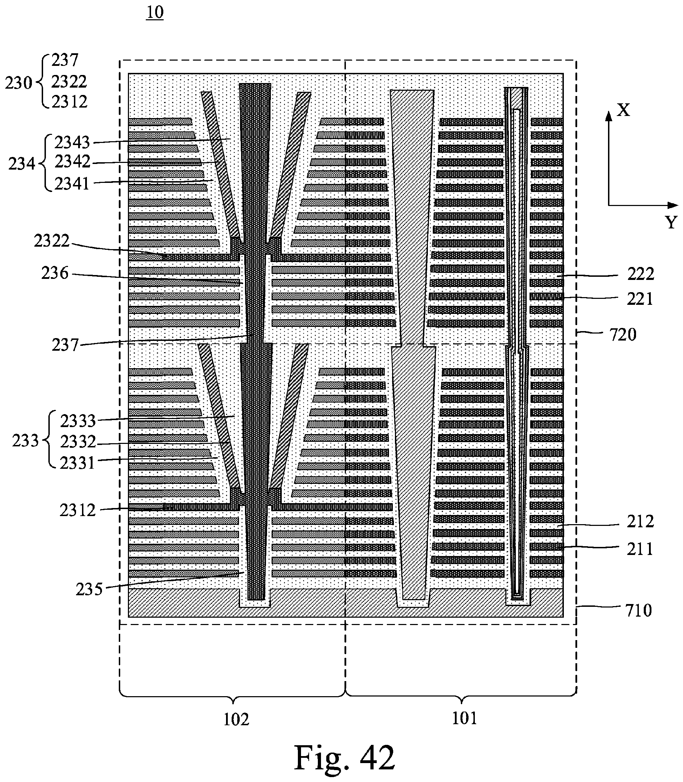

Referring to Figs. 41 and 42, after forming the third filling space 745 and the fourth filling space 746, the method further includes: filling a conductive material in the connection hole 730 to form the first connection structure 230.

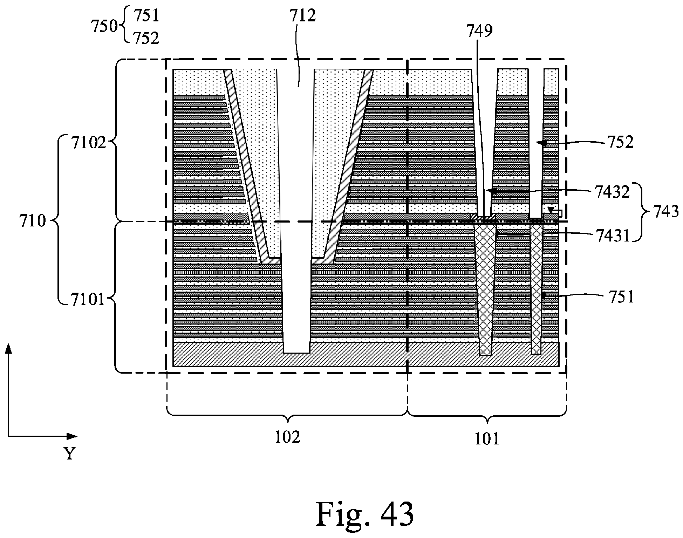

In some examples, as shown in Fig. 43, forming the first deck structure 710 includes: forming a first sub deck structure 7101 which includes a first sub gate line slit 7431 and a first channel hole 751.

In this operation, it is possible to form the first sub gate line slit 7431 and the first channel hole 751 on the first sub deck structure 7101 with an etch process. And the first sub gate line slit 7431 and the first channel hole 751 are located in the first region 101 of the first sub deck structure 7101.

Referring again to Fig. 43, it is possible to fill a sacrificial material in the first sub gate line slit 7431 and the first channel hole 751 after forming the first sub gate line slit 7431 and the first channel hole 751 to facilitate continuously forming the second sub deck structure 7102 on the first sub deck structure 7101 in the subsequent manufacturing operation.

Referring again to Fig. 43, after filling the sacrificial material in the first sub gate line slit 7431 and the first channel hole 751, the method further includes: forming an etch stop layer 749 on the first sub gate line slit 7431 and the first channel hole 751.

The second sub deck structure 7102 is formed on a side of the etch stop layer 749 away from the first sub gate line slit 7431 and the first channel hole 751, the second sub deck structure 7102 and the first sub deck structure 7101 together constitute the first stack structure 710.

The operation of removing a portion of first deck structure 710 to form the first connection hole 713 further includes: forming a second sub gate line slit 7432 and a second channel hole 752. The second sub gate line slit 7432 and the first sub gate line slit together constitute the first gate line slit, the second channel hole 752 and the first channel hole 751 together constitute the channel hole 750, and the first gate line slit and the channel hole 750 are located in the first region 101 of the first stack structure 710.

In this operation, as shown in Fig. 43, in the operation of removing a portion of first deck structure 710, the first connection hole 712, the second sub gate line slit 7432 and the second channel hole 752 are formed. However, the first connection hole 712 extends through the first sub deck structure 7101 and the second sub deck structure 7102, while the second sub gate line slit 7432 and the second channel hole 752 only extend through the second sub deck structure 7102, that is, the first connection hole 712 has an etch depth different from that of the second sub gate line slit 7432 and different from that of the second channel hole 752. Therefore, in this operation, before forming the second sub deck structure 7102, the etch stop layer 749 is formed on the first sub gate line slit 7431 and the first channel hole 751, which facilitates protecting the first sub gate line slit 7431 and the first channel hole 751 from being etched when forming the first connection hole 712, the second sub gate line slit 7432 and the second connection hole 752, thereby protecting the structure shape of the channel hole 750.

In the present example, the operation of forming the first deck structure 710 may include forming the first sub deck structure 7101 and the second sub deck structure 7102. Similarly, the second deck structure 720 may also be formed with two or more sub deck structures by the same manufacturing operation.

Some examples of the present disclosure further provide another manufacturing method of a memory device that will be described below with reference to Figs. 23-44.

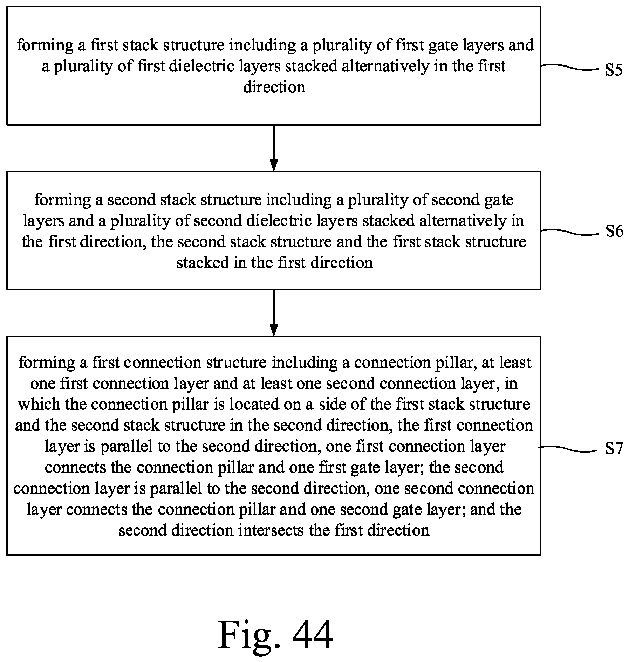

Fig. 44 is a flowchart of a manufacturing method of a memory device according to some other examples. As shown in Fig. 44, the manufacturing method of the memory device includes S5~S7.

S5, forming a first stack structure including a plurality of first gate layers and a plurality of first dielectric layers stacked alternatively in the first direction.

In this operation, referring to Fig. 42, it is possible to form the plurality of first gate layers 211 and the plurality of first dielectric layers 212 stacked alternatively in the first direction X with one or more film deposition processes including, but not limited to PVD, CVD and ALD.

S6, forming a second stack structure which includes a plurality of second gate layers and a plurality of second dielectric layers stacked alternatively in the first direction and stacks with the first stack structure in the first direction.

In this operation, referring to Fig. 42, it is possible to form the plurality of second gate layers 221 and the plurality of second dielectric layers 222 stacked alternatively in the first direction X on the first stack structure 210 with one or more film deposition processes including, but not limited to PVD, CVD and ALD.

S7, forming a first connection structure including a connection pillar, at least one first connection layer and at least one second connection layer, in which the connection pillar is located on a side of the first stack structure and the second stack structure in the second direction, the first connection layer is parallel to the second direction, one first connection layer connects the connection pillar and one first gate layer; the second connection layer is parallel to the second direction, one second connection layer connects the connection pillar and one second gate layer; and the second direction intersects the first direction.

In this operation, referring to Fig. 42, it is possible to form the first connection structure 230 on a side of the first stack structure 210 and the second stack structure 220 in the second direction Y with an etch process and a deposition process etc.

Illustratively, the constituting material for the first connection structure 230 may include conductive materials including, but not limited to a combination of one or more of tungsten (W), cobalt (Co), copper (Cu), aluminum (Al), polysilicon, doped silicon, silicide, or may also be other suitable conductive materials.

In the memory device 10 manufactured by the above-described operations, one SD device may be electrically connected with at least one first gate layer 211 and at least one second gate layer 221 through the first connection structure 230. One first gate layer 211 and one second gate layer 221 may share one first connection structure 230 and share one SD device. Then, when the memory device 10 has two stack structures, namely the first stack structure 210 and the second stack structure 220, as compared to the case in which one first gate layer 211 is connected with one SD device through one gate line contact G-CNT and one second gate layer 221 is connected with one SD device through one gate line contact G-CNT, in the present example, the number of the first connection structures 230 is smaller than the number of the gate line contacts G-CNT, and the number of the SD devices in the present example is also small. Therefore, the area occupied by the first connection structures 230 is smaller than the area occupied by the gate line contacts G-CNT, and at the same time the area occupied by the SD devices is reduced, which facilitates improving the memory density of the memory device 10.

In some examples, as shown in Fig. 23, forming the first stack structure 210 includes: forming a first deck structure 710, a first region 101 of the first deck structure 710 includes a plurality of first sacrificial layers 711 and a plurality of first dielectric layers 212 stacked in the first direction. The first region 101 of the first deck structure 710 is adjacent to the second region 102 of the first deck structure 710, the second region 102 of the first deck structure 710 is located on a side of the first region 101 of the first deck structure 710 in the second direction, and the second direction Y intersects the first direction X.

In this operation, as shown in Fig. 23, for example, the first dielectric layers 212 and the first sacrificial layers 711 may be formed alternatively with a deposition process. Illustratively, the material for the first dielectric layers 212 may be silicon oxide, and the material for the first sacrificial layers 711 may be silicon nitride.

Forming the second stack structure 220 includes forming a second deck structure 720, the second deck structure 720 and the first deck structure 710 are stacked in the first direction, a first region 101 of the second deck structure 720 includes the plurality of second sacrificial layers 721 and the plurality of second dielectric layers 222 stacked in the first direction, the first region 101 of the second deck structure 720 is adjacent to the second region 102 of the second deck structure 720, and the second region 102 of the second deck structure 720 is located on a side of the first region 101 of the second deck structure 720 in the second direction Y.

In this operation, as shown in Fig. 21, for example, the second dielectric layers 222 and the second sacrificial layers 721 are formed alternatively on the first deck structure 710 with a deposition process. Illustratively, the material for the second dielectric layers 222 may be silicon oxide, and the material for the second sacrificial layers 721 may be silicon nitride.

After forming the first deck structure 710, and before forming the second deck structure 720, the method includes: removing a portion of first deck structure 710 to form a first connection hole 712 which is located in the second region 102 of the first deck structure 710.

In this operation, as shown in Fig. 21, for example, the first connection hole 712 may be formed with an etching process.

A portion of the second deck structure 720 is removed to form a second connection hole 722 extending through the second region 102 of the second deck structure 720. The second connection hole 722 and the first connection hole 712 together constitute the connection hole.

As shown in Figs. 33 and 34, after forming the second deck structure 720, the method further includes: forming a first filling space 716 located in the second region 102 of the first deck structure 710 and in communication with the first connection hole 712 and forming a second filling space 726 located in the second region 102 of the first deck structure 710 and in communication with the second connection hole 722.

The above some examples may be referred to for the specific process operations for forming the first filling space 716 and the second filling space 726, which will not be described again herein.

As shown in Figs. 30, 31, 32 and 33, the first sacrificial layer 711 is replaced with the first gate layer 211 and the second sacrificial layer 721 is replaced with the second gate layer 221. At least one first gate layer 211 is in communication with the first filling space 716 and at least one second gate layer 221 is in communication with the second filling space 726.

Some examples described above may be referred to for the process steps for replacing the first sacrificial layer 711 with the first gate layer 211 and replacing the second sacrificial layer 721 with the second gate layer 221, which will not be described again herein.

As shown in Figs. 33 and 34, forming the first connection structure 230 includes: filling a conductive material in the connection hole 730 to form the first connection structure 230, wherein the conductive material filled in the connection hole 730 forms a connection pillar, the conductive material filled in the first filling space 716 forms a first connection layer 2312, the conductive material filled in the second filling space 726 forms a second connection layer 2322, the first connection layer 2312 is parallel to the second direction, one first connection layer 2312 connects the connection pillar 237 and one first gate layer 211, the second connection layer 2322 is parallel to the second direction, one second connection layer 2322 connects the connection pillar 237 and one second gate layer 221, and the connection pillar, the first connection layer 2312, and the second connection layer 2322 together constitute the first connection structure230.

In the memory device 10 manufactured by the above-described steps, one SD device may be electrically connected with at least one first gate layer 211 and at least one second gate layer 221 through the first connection structure 230. One first gate layer 211 and one second gate layer 221 may share one first connection structure 230 and share one SD device. It is beneficial to controlling the area occupied by the second region 102 and improving the memory density of the memory device 10.

Some examples of the present disclosure further provide another manufacturing method of the memory device that will be described below with reference to Figs. 21-46.

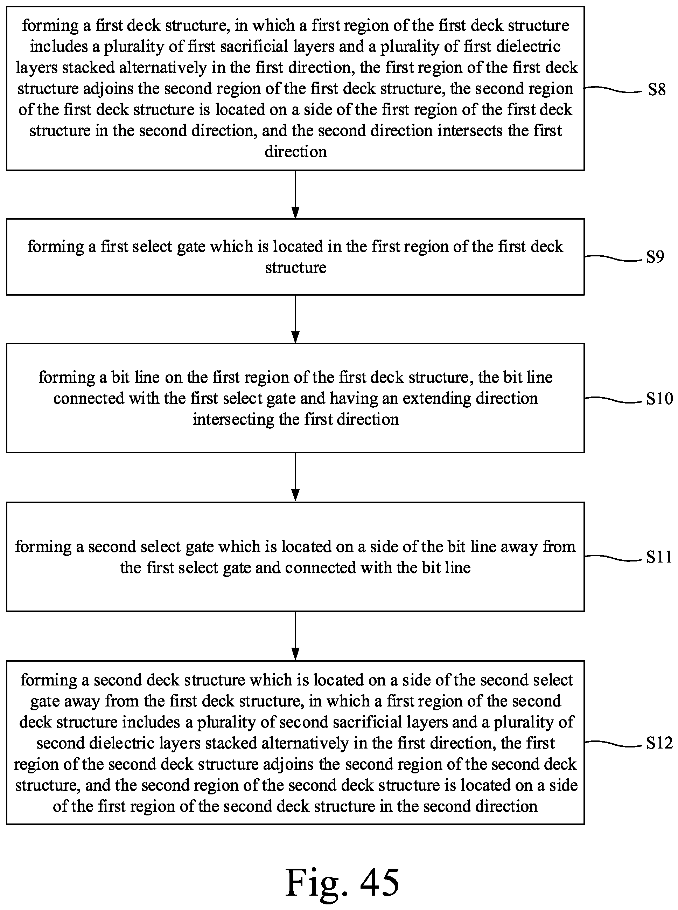

As shown in Fig. 45, the manufacturing method of the memory device as provided in some examples of the present disclosure includes S8~S12.

S8, forming a first deck structure, in which a first region of the first deck structure includes a plurality of first sacrificial layers and a plurality of first dielectric layers stacked alternatively in the first direction, the first region of the first deck structure adjoins the second region of the first deck structure, the second region of the first deck structure is located on a side of the first region of the first deck structure in the second direction, and the second direction intersects the first direction.

In this operation, as shown in Fig. 23, for example, the first dielectric layers 212 and the first sacrificial layers 711 may be formed alternatively with a deposition process. Illustratively, the material for the first dielectric layers 212 may be silicon oxide, and the material for the first sacrificial layers 711 may be silicon nitride.

S9, forming a first select gate which is located in the first region of the first deck structure.

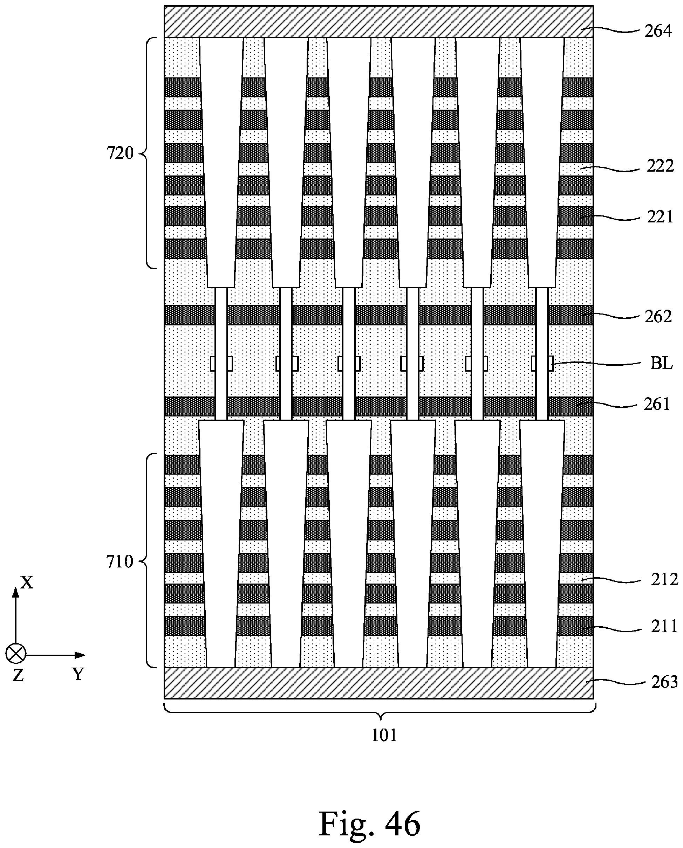

In this operation, referring to Fig. 46, the first select gate 261 is formed on the first deck structure 710, in which the first select gate 261 is located in the first region 101 of the first deck structure 710.

S10, forming a bit line on the first region of the first deck structure, in which the bit line is connected with the first select gate and has an extending direction intersecting the first direction.

In this operation, referring to Fig. 46, the bit line BL is formed on the first region 101 of the first deck structure 710 and the bit line BL has an extending direction intersecting the first direction X. Illustratively, the bit line BL may extend in the Y-Z plane. For example, the extending direction of the bit line BL may be parallel to the third direction Z.

S11, forming a second select gate which is located on a side of the bit line away from the first select gate and connects with the bit line.

In this operation, referring again to Fig. 46, the second select gate 262 is formed on a side of the bit line BL away from the first select gate 261 and is connected with the bit line BL.

S12, forming a second deck structure which is located on a side of the second select gate away from the first deck structure, in which a first region of the second deck structure includes a plurality of second sacrificial layers and a plurality of second dielectric layers stacked alternatively in the first direction, the first region of the second deck structure adjoins the second region of the second deck structure, and the second region of the second deck structure is located on a side of the first region of the second deck structure in the second direction.

In this operation, referring to Fig. 21, for example, the second dielectric layers 222 and the second sacrificial layers 721 may be formed alternatively on a side of the second select gate 262 away from the first deck structure 710 with a deposition process. Illustratively, the material for the second dielectric layers 222 may be silicon oxide, and the material for the second sacrificial layers 721 may be silicon nitride.

With the memory device 10 manufactured in this operation, the bit line BL is located between the first stack structure 210 and the second stack structure 220 and connected with the channel structure in the first stack structure 210 and also connected with the channel structure in the second stack structure 220. Therefore, the bit line BL may drive upwardly the channel structure in the first stack structure 210 and at the same time drive downwardly the channel structure in the second stack structure 220. As compared to the case in which the bit line BL are formed on the second stack structure, in the present example, forming the bit line BL between the first stack structure 210 and the second stack structure 220 facilitates improving the current intensity in the channel structure in the first stack structure 210 and the current intensity in the channel structure in the second stack structure 220, thereby mitigating the problem of weak current intensity in the channel structure away from the bit line BL.

In some examples, referring to Fig. 33, after forming the first deck structure 710, and before forming the second deck structure 720, the method includes: removing a portion of the first deck structure 710 to form a first connection hole 712 which is located in the second region 102 of the first deck structure 710. For example, the portion of the first deck structure 710 may be removed with an etch process.

After forming the second deck structure 720, the method further includes: removing a portion of the second deck structure 720 to form a second connection hole 722 which is located in the second region 102 of the second deck structure 720. The second connection hole 722 and the first connection hole 712 together constitute the connection hole 730. For example, the portion of the second deck structure 720 may be removed with an etch process.

After forming the connection hole 730, as shown in Figs. 33 and 37, the method further includes: replacing the first sacrificial layer 711 with the first gate layer 211 and replacing the second sacrificial layer 721 with the second gate layer 221. The first connection structure 230 is formed in the connection hole 730. The first connection structure 230 is connected with at least one first gate layer 211 and the first connection structure 230 is connected with at least one second gate layer 221.

In this operation, the first connection structure 230 may be formed in the connection hole 730 with one or more film deposition processes including, but not limited to PVD, CVD and ALD.

In the memory device 10 manufactured by the above-described manufacturing method, one SD device may be electrically connected with at least one first gate layer 211 and at least one second gate layer 221 through the first connection structure 230. One first gate layer 211 and one second gate layer 221 may share one first connection structure 230 and share one SD device, which is beneficial to controlling the area occupied by the second region 102 and improving the memory density.

Referring to Figs. 2, 3 and 8, some examples of the present disclosure further provides a memory system 1000 including a controller 20 and the memory device 10 provided in some examples described above (or the memory device 10 manufactured by the manufacturing method of the memory device provided in some examples described above), the controller 20 connected with the memory device 10. Illustratively, the controller 20 may be configured to manage data stored in the memory device 10 and communicate with external equipment such as a host. Alternatively, the controller may be further configured to control the operations of the memory device 10 such as reading, erasing and programming operations. Alternatively, the controller 20 may be further configured to manage various functions with respect to data stored or to be stored in the memory device 10. The memory system 1000 may be integrated into various types of storage apparatus. Some examples above may be referred to for details, which will not be described again herein.

Referring to Figs. 1, 2 and 8, some examples of the present disclosure further provide an electronic apparatus 3000 including a main board 2000 and the memory system 1000 provided in the above-described example. Some examples above may be referred to for the types of the electronic apparatus 3000, which will not be described again herein.

In the present example, the memory system 1000 includes the memory device 10 provided in some examples described above (or the memory device 10 manufactured by the manufacturing method of the memory device provided in some examples described above). In the memory device 10 provided in some examples described above, the plurality of gate layers may be led out to be connected with SD device through one first connection structure 230, and the plurality of gate layers may share one SD device, which facilitates improving the memory density of the memory device 10 and in turn improving the memory density of the memory system 1000, facilitates improving memory capacity of the electronic apparatus 3000 and facilitates the electronic apparatus 3000 to develop towards small size.

What have been described above are only some implementations of the present disclosure. The scope of the present disclosure is not limited thereto. Variations and substitutions that can be easily thought of by those skilled familiar with the technical field within the technical scope disclosed by the present disclosure should be encompassed in the scope of the present disclosure. Therefore, the scope of the present disclosure should be determined by the scope of the claims.

## Claims

1. A memory device comprising:
a first stack structure comprising a plurality of first gate layers and a plurality of first dielectric layers stacked alternatively in a first direction;
a second stack structure comprising a plurality of second gate layers and a plurality of second dielectric layers stacked alternatively in the first direction, the second stack structure and the first stack structure stacked in the first direction;
a first connection structure located on a side of the first stack structure and the second stack structure in a second direction, the first connection structure connected with at least one of the first gate layers and with at least one of the second gate layers, the second direction intersecting the first direction; and
a bit line located between the first stack structure and the second stack structure and having an extending direction intersecting the first direction.

2. The memory device of claim 1, wherein the first connection structure comprises a first connection sub-section and a second connection sub-section stacked in the first direction;
the first connection sub-section comprises a first connection pillar extending in the first direction and at least one first connection layer being parallel to the second direction, and one of the at least one first connection layer connects the first connection pillar and one of the first gate layers; and
the second connection sub-section comprises a second connection pillar extending in the first direction and connected with the first connection pillar and at least one second connection layer being parallel to the second direction, and one of the at least one second connection layer connects the second connection pillar and one of the second gate layers.

3. The memory device of claim 2, wherein the first connection sub-section and the second connection sub-section are an integral structure.

4. The memory device of claim 2, wherein in the second direction, a size of an end of the first connection pillar close to the second connection pillar is greater than a size of an end of the second connection pillar close to the first connection pillar.

5. The memory device of claim 4, wherein,
in the second direction, the size of the end of the first connection pillar close to the second connection pillar is greater than a size of an end of the first connection pillar away from the second connection pillar; and/or
in the second direction, a size of an end of the second connection pillar away from the first connection pillar is greater than the size of the end of the second connection pillar close to the first connection pillar.

6. The memory device of claim 2, wherein the first connection structure further comprises a first isolation layer and a second isolation layer;
the first isolation layer is located on a side of the first connection layer close to the second connection layer, and surrounds the first connection pillar; and
the second isolation layer is located on a side of the second connection layer away from the first connection layer, and surrounds the second connection pillar.

7. The memory device of claim 6, wherein a size of an end of the first isolation layer away from the first connection layer and in the second direction is greater than a size of an end of the first isolation layer close to the first connection layer and in the second direction.

8. The memory device of claim 6, wherein the first connection structure further comprises a third isolation layer and a fourth isolation layer;
the third isolation layer is located on a side of the first connection layer away from the first isolation layer, and the third isolation layer contacts and surrounds the first connection pillar; and
the fourth isolation layer is located on a side of the second connection layer away from the second isolation layer, and the fourth isolation layer contacts and surrounds the second connection pillar.

9. The memory device of any one of claims 6-8, wherein the first connection layer comprises a first sub-layer and a second sub-layer stacked in the first direction, the first sub-layer is located between the first isolation layer and the second sub-layer, and the first isolation layer surrounds the first sub-layer.

10. The memory device of any one of claims 6-8, further comprising a third connection layer, the third connection layer surrounding the connection pillar and connected with the first connection pillar, wherein in the first direction, an edge of the third connection layer on a side away from the first isolation layer is connected with the first connection layer; and
the first connection layer surrounds the third connection layer and is connected with the first gate layer.

11. The memory device of claim 10, wherein the first isolation layer comprises a first sub isolation layer, a second sub isolation layer and a third sub isolation layer;
the first sub isolation layer surrounds the connection pillar;
the second sub isolation layer is located between the first sub isolation layer and the connection pillar and surrounds the connection pillar; and
the third sub isolation layer is located between the second sub isolation layer and the connection pillar and surrounds the connection pillar.

12. The memory device of claim 11, wherein an edge of the third connection layer on a side close to the second sub isolation layer extends toward a direction close to the second sub isolation layer.

13. The memory device of any one of claims 1-8, further comprising:
a first select gate located on a side of the first stack structure away from the second stack structure;
a second select gate located on a side of the first stack structure close to the second stack structure;
a third select gate located on a side of the second stack structure close to the first stack structure, and the bit line connects the second select gate and the third select gate; and
a fourth select gate located on a side of the second stack structure away from the first stack structure.

14. The memory device of claim 13, wherein the first stack structure comprises:
a first sub stack structure and a second sub stack structure stacked in the first direction; and
a first channel structure extending through the first sub stack structure and a second channel structure extending through the second sub stack structure,
the first channel structure is located between the first select gate and the second select gate.

15. The memory device of any one of claims 2-8, wherein the memory device comprises a first region and a second region, the first region adjoins the second region, the first stack structure and the second stack structure are both located in the first region, and the first connection structure is located in the second region;
the second region is located on a side of the first region; or
the first region comprises a first sub-region and a second sub-region and the second region is located between the first sub-region and the second sub-region.

16. The memory device of claim 15, further comprising a third stack structure and a fourth stack structure stacked in the first direction, wherein the third stack structure and the fourth stack structure are both located in the second region;
the first connection pillar extends through the third stack structure that comprises a plurality of third dielectric layers and a plurality of fourth dielectric layers stacked alternatively in the first direction, and at least one of the third dielectric layers is connected with at least one of the at least one first connection layer; and
the second connection pillar extends through the fourth stack structure that comprises a plurality of fifth dielectric layers and a plurality of sixth dielectric layers stacked alternatively in the first direction, and at least one of the fifth dielectric layers is connected with at least one of the at least one second connection layer.

17. The memory device of claim 14, further comprising a second connection structure, wherein
the second connection structure is located on a side of the first stack structure and the second stack structure in the second direction; and
one of the first select gate and the second select gate is connected with the second connection structure.

18. A memory device comprising:
a first stack structure comprising a plurality of first gate layers and a plurality of first dielectric layers stacked alternatively in a first direction;
a second stack structure comprising a plurality of second gate layers and a plurality of second dielectric layers stacked alternatively in the first direction, the second stack structure and the first stack structure stacked in the first direction; and
a first connection structure comprising a connection pillar, at least one first connection layer and at least one second connection layer, wherein the connection pillar is located on a side of the first stack structure and the second stack structure in a second direction, the first connection layer is parallel to the second direction, one of the at least one first connection layer connects the connection pillar and one of the first gate layers, the second connection layer is parallel to the second direction, one of the at least one second connection layer connects the connection pillar and one of the second gate layers, and the second direction intersects the first direction.

19. The memory device of claim 18, further comprising:
a first select gate located on a side of the first stack structure away from the second stack structure;
a second select gate located on a side of the first stack structure close to the second stack structure;
a third select gate located on a side of the second stack structure close to the first stack structure;
a fourth select gate located on a side of the second stack structure away from the first stack structure; and
a second connection structure located on a side of the first stack structure and the second stack structure in the second direction,
wherein one of the first select gate, the second select gate, the third select gate and the fourth select gate is connected with the second connection structure.

20. The memory device of claim 19, further comprising:
a first bit line and a second bit line, wherein the first bit line is located on a side of the first select gate away from the first stack structure, the second bit line is located on a side of the fourth select gate away from the first stack structure, and the first bit line and the second bit line have an extending direction intersecting the first direction.

21. The memory device of claim 18, wherein the memory device comprises a first region and a second region, the first region adjoins the second region in the second direction, the first stack structure and the second stack structure are both located in the first region, and the first connection structure is located in the second region;
the second region is located on a side of the first region; or
the first region comprises a first sub-region and a second sub-region and the second region is located between the first sub-region and the second sub-region.

22. A memory device comprising:
a first stack structure and a second stack structure stacked in a first direction, the first stack structure comprising a plurality of first gate layers and a plurality of first dielectric layers stacked alternatively in the first direction, the second stack structure comprising a plurality of second gate layers and a plurality of second dielectric layers stacked alternatively in the first direction;
a first select gate located on a side of the first stack structure close to the second stack structure, and a second select gate located on a side of the second stack structure close to the first stack structure; and
a bit line located between the first select gate and the second select gate and having an extending direction intersecting the first direction.

23. The memory device of claim 22, further comprising a first connection structure, wherein
the first connection structure is located on a side of the first stack structure and the second stack structure in a second direction, the first connection structure is connected with at least one of the at least one first gate layer and with at least one of the at least one second gate layer, and the second direction intersects the first direction.

24. The memory device of claim 22, further comprising:
a third select gate located on a side of the first stack structure away from the second stack structure, and a fourth select gate located on a side of the second stack structure away from the first stack structure; and
a second connection structure located on a side of the first stack structure and the second stack structure in the second direction,
wherein one of the first select gate, the second select gate, the third select gate and the fourth select gate is connected with the second connection structure.
